(19) Europäisches Patentamt
European Patent Office
Office européen des brevets

(11) Veröffentlichungsnummer: **0 192 937**
**B1**

(12) # EUROPÄISCHE PATENTSCHRIFT

(45) Veröffentlichungstag der Patentschrift: **24.10.90**

(51) Int. Cl.⁵: **B 32 B 15/08,** C 08 G 73/10

(21) Anmeldenummer: **86100430.7**

(22) Anmeldetag: **15.01.86**

(60) **Ein Antrag gemäss Regel 88 EPÜ auf Hinzufügung der fehlenden Seite 10 der Beschreibung wurde am 7.2.1986 eingerecht.**

(54) **Flexible polyimid-Mehrschichtlaminate.**

(30) Priorität: **25.02.85 DE 3506524**

(43) Veröffentlichungstag der Anmeldung:
**03.09.86 Patentblatt 86/36**

(45) Bekanntmachung des Hinweises auf die Patenterteilung:
**24.10.90 Patentblatt 90/43**

(84) Benannte Vertragsstaaten:
**AT BE CH DE FR GB IT LI LU NL SE**

(56) Entgegenhaltungen:
**EP-A-0 048 315**
**EP-A-0 116 297**
**DE-A-3 215 944**
**US-A-3 900 662**

(73) Patentinhaber: **Akzo Patente GmbH**
**Postfach 10 01 49 Kasinostrasse 19-23**
**D-5600 Wuppertal-1 (DE)**

(72) Erfinder: **Kundinger, Ernst F., Dipl.-Chem.**
**Odenwaldring 28**
**D-6127 Breuberg/Neustadt (DE)**
Erfinder: **Klimesch, Erich**
**Berliner Strasse 11**
**D-8765 Erlenbach (DE)**
Erfinder: **Zengel, Hans G., Dr. Dipl.-Ing.**
**Nordring 6**
**D-8751 Kleinwallstadt (DE)**
Erfinder: **Lasher, Jeffery D.**
**20 Alfred Drive**
**Tolland Connecticut 06084 (US)**

**EP 0 192 937 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die Erfindung betrifft eine flexibles Mehrschichtlaminat, welches ein single clad aus einer Schicht aus nicht mehr formbarem vollaromatischem Polyimid und einer Schicht aus Trägermaterial enthält, wobei die Schicht aus nicht mehr formbarem Polyimid an einer Seite direkt an der Schicht aus Trägermaterial mit einer Schälfestigkeit von mindestens 4,0 N/cm haftet, wobei das nicht mehr formbare Polyimid in phenolischen Lösungsmitteln unlöslich ist und die Schicht aus nicht mehr formbarem Polyimid eine Zugfestigkeit von 100 bis 150 $N/mm^2$, eine Bruchdehnung von 15—100% und einen dielektrischen Verlustfaktor von $1{,}5 \times 10^{-3}$ bis $5 \times 10^{-3}$ bei 1 kHz aufweist.

Sie betrifft ebenfalls ein Verfahren zur Herstellung dieser Laminate.

Single clads der genannten Art sind aus der EP—A 0 116 297 bekannt.

Laminate, die eine oder mehrere Schichten aus Polyimid und eine oder mehrere Schichten aus Trägermaterial enthalten, lassen sich vielseitig verwenden, so z.B. als Verstärkungsmaterialien. Daneben werden solche Laminate in Form mit Polyimid beschichteter Metallfolien für gedruckte elektrische Schaltungen eingesetzt. Hierbei macht man von der Flexibilität sowie den hervorragenden mechanischen, thermischen und elektrischen Eigenschaften der Polyimide Gebrauch. Die Laminate werden nämlich bei der Weiterverarbeitung, z.B. beim Löten oder Bohren häufig hohen Temperaturen ausgesetzt. An die Laminate werden auch hohe Anforderungen bezüglich der elektrischen und mechanischen Eigenschaften gestellt. Laminate, welche nur eine Trägerschicht aus Metall oder einer Metallegierung und eine Schicht aus Polyimid enthalten, sogenannte single clads, können für gedruckte elektrische Schaltungen ebenso verwendet werden wie Mehrschichtlaminate, sogenannte double clads oder mehrfach-clads, die mehrere Metallschichten und/oder mehrere Polyimidschichten aufweisen. In bestimmten Fällen jedoch sind Mehrschichtlaminate den single clads überlegen. So ist es z.B. bei gedruckten elektrischen Schaltungen häufig nötig, Schaltbahnen zu legen, die einander überkreuzen. Bei Verwendung von single clads lassen sich die oft gewünschten hohen Packungsdichten, d.h. niedrige Gesamtschichtdicken, nicht erzielen, sondern nur bei Verwendung von Mehrschichtlaminaten, also von double clads oder Mehrfach-clads. Gegenstand der vorliegenden Erfindung sind Mehrschichtlaminate in Form von double clads bzw. Mehrfach-clads. Unter double clads sind hierbei Laminate zu verstehen, welche zwei (metallische) Trägerschichten und zwei Polyimidschichten enthalten, und unter Mehrfachclads solche, welche mehr als zwei (metallische) Trägerschichten und/oder mehr als zwei Polyimidschichten enthalten.

Laminate, welche Polyimide und Trägermaterialien enthalten, sind bekannt. Hierbei sind, vielfach die Polyimidschichten über einen herkömmlichen Klebstoff an die Trägermaterialien gebunden. So beschreibt z.B. die *US—PS 3.900.662* die Verbindung von Polyimid mit Metall über eine Klebschicht auf Acrylatbasis. Auch in dem in der *US—PS 3.822.175* beschriebenen Gegenstand wird von dieser Möglichkeit Gebrauch gemacht.

Stellt man entsprechend der Lehren dieser Schriften double clads oder Mehrfach-clads her, in denen sich jeweils zwischen der Metallschicht und der Polyimidschicht eine Schicht aus einem Acrylatkleber befindet, so weisen die erhaltenen Produkte eine Reihe von Nachteilen auf:

a) die Gesamtschichtdicke der clads ist groß wegen der erforderlichen Klebeschichten, während bei Mehrfachclads niedrige Gesamtschichtdicke erwünscht ist

b) die Metall-(Trägermaterial)schicht ist direkt mit Acrylat verbunden, das dem Polyimid hinsichtlich thermischer Formbeständigkeit unterlegen ist. So kommt es bei der Herrichtung der clads für gedruckte Schaltkreise häufig zu dem gefürchteten "Schwimmen". Dieses "Schwimmen" resultiert aus einer Veränderung der Acrylatschicht unter den hohen temperaturen, die z.B. beim Löten und Bohren an der Metallschicht angewandt werden. Da das Acrylat direkt mit der Metallschicht verbunden ist, ist es nicht ausreichend vor diesen hohen Temperaturen geschützt

c) da das Acrylat schlechtere elektrische Isoliereigenschaften aufweist als das Polyimid, wirkt sich die Klebeschicht bzw. wirken sich Klebeschichten zwischen Polyimid und Trägermaterial (Metall) verschlechternd auf die dielektrischen Eigenschaften aus.

Es hat sich gezeigt, daß bei Verwendung herkömmlicher Klebstoffe z.B. auf Basis Acrylat, Epoxid, Polyamid, Phenolharz usw. die Laminate, in denen das Polyimid über eine verklebende Zwischenschicht aus einem dieser Klebstoffe an das Metall gebunden ist, keine voll befriedigenden Eigenschaften aufweisen, die den vielfach gestellten hohen Anforderungen genügen.

Wegen der Nachteile der Laminate, die Klebeschichten aus herkömmlichen Klebstoffen zwischen Polyimid un Metall enthalten, wurden mehrschichtlaminate vorgeschlagen, in denen das Polyimid direkt, also ohne verklebende Zwischenschicht, an Metall gebunden ist. So beschreibt z.B. die *DE—OS 32 15 944* Laminate, in denen zwei Metallschichten über eine Zwischenschicht aus Polyimid verbunden sind. Das hierbei verwendete Polyimid ist zum überwiegenden Teil auf Basis von Diphenyltetracarbonsäure aufgebaut und läßt sich bei Anwendung von hohem Druck und hoher Temperatur mit einer Metallfolie verbinden. Es handelt sich hierbei also um ein formbares Polyimid. Nun hat sich jedoch gezeigt, daß formbare Polyimide oder Polyimide, welche in phenolischen Lösungsmitteln löslich sind, in ihrer thermischen Stabilität den nicht mehr formbaren, vollaromatischen, in phenolischen Lösungsmitteln unlöslichen Polyimiden unterlegen sind. Double clads, die als Isolierschicht ausschließlich diese formbaren Polyimide enthalten, unterliegen der Gefahr, daß beim Laminieren das Polymer teilweise wegfließt und die Metallflächen in direkten Kontakt kommen. Daher sind clads, in denen nur diese formbaren Polyimide

enthalten sind, Produkten unterlegen, welche nicht mehr formbare Polyimide als isolierende Schicht(en) enthalten.

Es wurden wegen der Nachteile von clads, die jeweils Klebstoffe zwischen Metall und Polyimid enthalten, bereits single clads aus einem Trägermaterial, an das ein nicht mehr formbares, vollaromatisches, in phenolischen Lösungsmitteln unlösliches Polyimid direkt gebunden ist, vorgeschlagen z.B. in der EP—A 0 116 297. Diese single clads weisen hervorragende mechanische thermische und elektrische Eigenschaften auf. Wie man ausgehend von solchen single clads zu double clads oder Mehrfach-clads mit guten Eigenschaften gelangen kann, ist der EP—A 0 116 297 jedoch nicht zu entnehmen.

Ausgehend von diesen single clads wären Mehrfachlaminate wünschenwert, die ebenfalls nur aus Trägermaterialien und diesen nicht mehr formbaren, vollaromatischen Polyimiden bestehen und die somit die gleichen mechanischen, thermischen und elektrischen Eigenschaften besitzen. Es hat sich jedoch gezeigt, daß es nicht möglich ist, zwei oder mehrere single clads dieser Art direkt miteinander zu verbinden oder ein solches single clad direkt, d.h. ohne verklebende Zwischenschicht, mit einem metallischen Trägermaterial zu verbinden, da auf die vollständig ausgehärtete Polyimidschicht keine weitere Schicht aus Trägermaterial oder kein weiteres single clad ohne Zwischenschicht so aufgebracht werden kann, daß eine hohe Schälfestigkeit resultiert, d.h. eine hohe Haftung zwischen Polyimid und der zusätzlich aufgebrachten Schicht. Andererseits ist zwar das Aufbringen der weiteren Schicht aus Trägermaterial vor vollständiger Aushärtung des Polyimids prinzipiell möglich und führt zu einer Erhöhung der Schälfestigkeit. Es kann jedoch hierbei zu Blasenbildung in der Polyimidschicht kommen, da bei deren Aushärtung flüchtige Bestandteile, z.B. Wasser, entweichen müssen und das Freisetzen dieser flüchtigen Bestandteile durch die zusätzliche Schicht aus Trägermaterial gestört werden kann.

Es wurde nun überraschend gefunden, daß die Nachteile der bekannten Mehrschichtlaminate überwunden werden können durch Laminate gemäß Oberbegriff von Anspruch 1, die dadurch gekennzeichnet sind, daß zwei solcher single clads über die den Trägermaterialien abgewandten Seiten der beiden Polyimidschichten mittels einer Schicht aus heißsiegelbarem Hochtemperaturklebstoff, der aus der Klasse der Polyacrylate, Polysulfonharze, Epoxiharze, Fluorpolymerharze, Silikonharze oder Butylkautschuke ausgewählt ist, miteinander verbunden sind.

In diesen Laminaten ist der Hocktemperaturklebstoff, der bezüglich seiner thermischen und elektrischen (isolierenden) Eigenschaften dem nicht mehr formbaren Polyimid unterlegen ist, nicht mit dem Trägermaterial (Metall) verbunden. Er wird einerseits durch die Polyimidschicht vor den hohen Temperaturen geschützt, die bei der Bearbeitung der Metalloberfläche auftreten können. Andererseits ergab sich der überraschende Befund, daß auch die dielektrischen Eigenschaften der Laminate dadurch verbessert werden können, daß sich zwischen der Metall- und der Klebstoffschicht eine Schicht aus Polyimid befindet. So zeigt sich beispielsweise für den Fall der Polyacrylate als Klebstoffschicht, daß die dielektrischen (isolierenden) Eigenschaften der erfindungsgemäßen Laminate deutlich besser sind, als man aus der Summe der dielektrischen Eingenschaften der Einzelprodukte berechnen würde.

Diese erfindungsgemäßen double clads bzw. Mehrfachclads weisen dielektrische Eigenschaften auf, die sehr nahe bei denen liegen, welche Laminate (z.B. single clads) besitzen, die nur Trägermaterial und Polyimid enthalten. Die schlechteren dielektrischen Eigenschaften von z.B. Polyacrylaten wirken sich überraschenderweise kaum noch aus, ganz im Gegensatz zu Produkten, in denen Polyacrylat direkt mit Trägermaterial (Metall) verbunden ist. Es wird angenommen, daß die "Einbettung" der Acrylatschicht zwischen zwei Polyimidschichten hierfür verantwortlich ist.

Darüber hinaus ist in den erfindungsgemäßen Laminaten (double clads oder Mehrfachclads) die Anzahl der erforderlichen Klebeschichten vermindert gegenüber Produkten, welche zwischen jeder Polyimidschicht und jeder Trägermaterialschicht eine Klebstoffschicht enthalten. Dies erhöht den relativen Anteil von Polymid in der Polymerschicht und damit die thermische Beständigkeit, verbessert die dielektrischen Eigenschaften und ermöglicht niedrigere Gesamtschichtdicken der double clads und Mehrfachclads.

Die erfindungsgemäßen Laminate enthalten somit mindestens zwei Schichten aus nicht mehr formbarem Polyimid, wovon jede an einer ihrer beiden Seiten direkt, d.h. ohne eine Zwischenschicht, an einer Schicht aus Trägermaterial haftet. Die Schälfestigkeit des Gebildes aus nicht mehr formbarem Polyimid und Trägermaterial, gemessen nach der in IPC TM 650, 2.4.9 angegebenen Methode, beträgt mindestens 4.0 N/cm. Auf der jeweils anderen Seite bzw. Oberfläche der beiden Schichten aus nicht mehr formbarem Polyimid befindet sich eine Schicht aus enem heißsiegelbaren Hochtemperaturklebstoff. Die erfindungsgemäßen Laminate enthalten somit mindestens eine Element, das folgendermaßen aufgebaut ist:

Trägermaterial/nicht mehr formbares Polyimid/heißsiegelbarer Hochtemperaturklebstoff/nicht mehr formbares Polyimid/Trägermaterial. Jede Schicht aus nicht mehr formbarem Polyimid besitzt eine Zugfestigkeit von 100 bis 150 N/mm$^2$, gemessen nach ASTM D 882, eine Bruchdehnung von 15 bis 100%, gemessen nach ASTM D 882 sowie einen dielektrischen Verlustfaktor von $1{,}5 \times 10^{-3}$ $5 \times 10^{-3}$ bei 1 kHz, gemessen nach ASTM D—150.

Unter "nicht mehr formbaren, vollaromatischen, in phenolischen Lösungsmitteln unlöslichen Polyimiden" werden hierbei Polyimide verstanden, die aus aromatischen Tetracarbonsäuren bzw. deren Dianhydriden und aus primären aromatischen Diaminen erhalten werden, wobei jede Carboxyl- bzw.

primäre Aminogruppe direkt an einen aromatischen Ring gebunden ist. Ferner sind die Polyimide nicht unzersetzt schmelzbar und in herkömmlichen Lösungsmittel, also auch in phenolischen Lösungsmitteln wie Phenol, Kresolen und halogenierten Phenolen, unlöslich. Es ist also bei diesen Polyimiden weder über Schmelzen noch über Lösen eine neue Formgebung möglich.

Neben dem Grundkörper, nämlich

a) double clads mit dem Aufbau:

Trägermaterial/nicht mehr formbares Polyimid/heißsiegelbarer Hochtemperaturklebstoff/nicht mehr formbares Polyimid/Trägermaterial

können die erfindungsgemäßen Laminate auch folgende Ausführungsformen aufweisen:

b) double clads mit dem Aufbau:

Trägermaterial/nicht mehr formbares Polyimid/heißsiegelbarer Hochtemperaturklebstoff/ heißsiegelbarer Hocktemperaturklebstoff/nicht mehr formbares Polyimid/Trägermaterial

c) Mehrfachclads, bei denen die außenliegende Oberfläche einer oder beider Trägermaterialschicht(en) der unter a) oder b) genannten Laminate direkt mit nicht mehr formbaren Polyimid verbunden ist. Diese Produkte sind also dadurch gekennzwichnet, daß sie mindestens eine Schicht aus Trägermaterial enthalten, die auf beiden Seiten mit je einer Schicht aus nicht mehr formbarem Polyimid verbunden ist.

Die unter c) beschriebenen Laminate stellen bevorzugte Ausführungsformen der erfindungsgemäßen Laminate dar. Ihre Herstellung wird weiter unten beschrieben.

Die Produkte a) und b) unterscheiden sich dadurch, daß in einem Fall nur eine Schicht aus heißsiegelbarem Hocktemperaturklebstoff vorliegt, im anderen zwei Schichten, die jedoch mehr oder weniger ineinander übergehen können. Bei den unter a) und b) genannten Produkten können sowhol die beiden Schichten aus nicht mehr formbarem Polyimid als auch die beiden Schichten aus Trägermaterial jeweils gleiche oder voneinander verschiedene chemische Struktur und/oder Schichtdicke aufweisen. Für die unter b) genannten Produkte gilt dies zusätzlich für die beiden Schichten aus heißsiegelbarem Hochtemperaturklebstoff. Mit anderen Worten: Bei der Herstellung von double clads können zwei gleiche oder zwei verschiedene single clads verwendet werden.

Bei den unter a) und b) genannten Produkten sind somit zwei Schichten aus nicht mehr formbaren Polyimiden (die beide direkt an je einer Seite mit Trägermaterial verbunden sind) jeweils auf der dem Trägermaterial abgewandten Seite mittels heißsiegelbarem Hocktemperaturklebstoff miteinander verbunden. Das Zusammenfügen zweier (gleicher oder verschiedener) single clads jeweils an der Schicht aus hießsiegelbarem Hochtemperaturklebstoff führt zu den unter b) genannten Produkten. Die unter a) genannten Produkte entstehen z.B. dann, wenn zwei der single clads so miteinander verbunden sind, daß die beiden ursprunglich getrennten Schichten aus heißsiegelbarem Hochtemperaturklebstoff ineinander übergehen und im fertigen Produkt nut noch eine einzige definierte Schicht bilden.

Da bei Verwendung der erfindungsgemäßen Laminate für gedruckte elektrische Schaltungen als Trägermaterialien Metalle oder Legierungen verwendet und bei Weiterverarbeitung der Laminate hohe Temperaturen angewandt werden, besteht somit ein Vorteil der erfindungsgemäßen Laminate (double clads bzw. Mehrfachclads) darin, daß der heißsiegelbare Hocktemperaturklebstoff nicht mit Metall, sondern mit dem nicht mehr formbaren Polyimid verbunden ist. Auf diese Weise wird der thermisch weniger stabile heißsiegelbare Hocktemperaturklebstoff durch das stabilere Polyimid geschützt, da die hohen Temperaturen an der Metallschicht, z.B. beim Löten, vorliegen. Dadurch, daß in den erfindungsgemaßen Laminaten jeweils Schichten aus Trägermaterial, z.B. Metall, vorliegen, die an einer oder beiden Seiten direkt mit nicht mehr formbarem Polyimid verbunden sind, ist die Anzahl der erforderlichen Klebeschichten auf ein Minimum reduziert. Dies ist deshalb von großer Bedeutung, weil dadurch die thermische Stabilität der Produkte erhöht sowie ihre Gesamtschichtdicke erniedrigt werden kann.

Es ist, wie oben erwähnt, vorteilhaft, wenn eine oder beide Schicht(en) aus Trägermaterial auf jeweils beiden Seiten mit einer Schicht aus nicht mehr formbarem, vollaromatischem Polyimid verbunden ist bzw. sind. Auf diese Weise kann man zu Vielfach-clads gelangen, die auch bei gedruckten elektrischen Schaltungen komplexen Aufbaus hohe Packungsdichte ermöglichen.

Es können in diesem Fall auf einer oder beiden außenliegenden Oberfläche(n), die nunmehr aus nicht mehr formbarem Polyimid besteht bzw. bestehen, auch weitere Schichten angebracht sein, unter denen sich auch andere Materialien als Polyimide befinden können, wenn der vorgesehene Verwendungszweck dies gestattet.

Als nicht mehr formbare, vollaromatische Polyimide werden bevorzugt Verbindungen verwendet, welche die in den Ansprüchen 7 und 8 angegebenen Struktureinheiten aufweisen. Diese Polyimide können durch Umsetzung von Tetracarbonsäuren oder deren Mono- oder Dianhydriden mit Diaminen erhalten werden. Beispiele für geeignete Dianhydride sind Pyromellitsaüredianhydride, 2,3,6,7-Naphthalintetracarbonsäuredianhydrid, 3,4,3',4'-Diphenylsulfontetracarbonsäuredianhydrid, Perylen-3,4,9,10-tetracarbonsäuredianhydrid, 3,4,3',4'-Diphenylläthertetracarbonsäuredianhydrid.

Beispiele für Diamine, die mit den Tetracarbonsäuren bzw. deren Derivaten zu geeigneten nicht mehr formbaren, vollaromatischen Polyimiden umgesetzt werden können, sind: 4,4'-Diaminodiphenyläther; 5-Amino-2(p-Aminophenyl)-Benzothiazol; 4-Amino-2-(p-Aminophenyl)-Benzothiazol; 5-Amino-2-(m-Aminophenyl)-Benzothiazol; 5-Amino-2-(p-Aminophenyl)-Benzoxazol; 4-Amino-2-(m-Aminophenyl)-Benzothiazol; p- und m-Phenylen diamin; 4,4'-Diamino-Diphenyl; Bis-(4-Aminophenyl)-Methan; 4-Amino-2-(p-Aminophenyl)-Benzoxazol; 4-Amino-2-(m-aminophenyl)-benzoxazol; 5-Amino-2-(m-Aminophenyl)-Benzoxozol: 2,5-Diamino-Benzoxazol: 2,5-Diamino-Benzothiazol.

Als besonders geeignet hat sich das durch Umsetzung von Pyromellitsäuredianhydrid (PMDA) mit 4,4'-Diaminodiphenyläther (DADE) erhältliche Polyimid erwiesen.

Die erfindungsgemäßen Laminate enthalten Schicht(en) aus heißsiegelbarem Hochtemperaturklebstoff. Dieser Klebstoff ist aus der Klasse der Polyacrylate, Polysulfonharze, Epoxiharze, Fluorpolymerharze, Silikonharz oder Butyl-kautschuke ausgewählt.

Unter hießsiegelbaren Hocktemperaturklebstoffen sind solche Produkte aus den erwähnten Gruppen zu verstehen, welche bei einer Temperatur im Bereich von 140 bis 500°C formbar sind, ggf. unter Anwendung von Druck, und dabei eine verklebende Wirkung aufweisen. Sie dürfen ferner nicht unterhalb von 200°C schmelzen. Es ist jedoch nicht erforderlich, daß die als Hochtemperaturklebstoffe verwendeten Produkte, überhaupt einen definierten Schmelzpunkt oder -bereich aufweisen. Es genügt, wenn sie, ohne zu schmelzen, einer Formgebung im angegebenen Temperaturbereich zugänglich sind. Die Hocktemperaturklebstoffe müssen, wie erwähnt, eine verklebende Wirkung aufweisen. Darunter ist zu verstehen, daß ein Laminat aus Polyimid und Klebstoff, das wie nachfolgend beschrieben hergestellt ist, eine Schälfestigkeit, gemessen nach der in IPC TM 650, 2.4.9 angegebenen Methode, von mindestens 2,0 N/cm aufweisen muß. Das für diesen Test verwendete Laminat wird folgendermaßen hergestellt: Ein single clad aus Metall und Polyimid wird nach einem der unten in den Beispielen 1 bis 3 angegebenen Verfahren hergestellt. Auf die Polyimidschicht dieses single clads wird der zu testende Klebstoff in Form einer Lösung oder als Folie aufgetragen und im ersteren Fall das Lösungsmittel durch Erhitzen entfernt. Anschließend wird bei einer Temperatur im Bereich zwischen 140 und 500°C hießversiegelt, ggf. unter Anwendung von Druck. Die geeigneten Temperatur und Druckbedingungen hängen von der Art des Klebstoffs ab und lassen sich durch einfache Versuche ermitteln. Nach Entfernen der Metallschicht, z.B. durch Abätzen, kann die Schälfestigkeit bestimmt werden. Produkte, welche für den gesamten oben angegebenen Temperaturbereich auch bei Anwendung von Druck keine Schälfestigkeit von mindestens 2,0 N/cm ergeben, sind als Klebstoffe für die erfindungsgemäßen Laminate ungeeignet.

Die Forderung, daß die Klebstoffe bei einer Temperatur im Bereich von 140 bis 500°C heißsiegelbar, d.h. formbar sein müssen, bedeutet nicht, daß alle Klebstoffe, die diese Forderung erfüllen, für alle Verwendungszwecke der erfindungsgemäßen Laminate geeignet sind. Vielmehr kann es erforderlich sein, daß für einen bestimmten Verwendungszweck nur Klebstoffe verwendet werden, die erst bei 250°C oder höher formbar sind.

Es ist vorteilhaft, wenn in den erfingungsgemäßen Laminaten der Schichtverbund aus Polyimid und Klebstoff eine Schälfestigkeit von mehr als 4,0 N/cm aufweist.

Die Dicke der Schichten aus nicht mehr formbarem Polyimid, welchen z.B. im Fall der Verwendung der Laminate für gedruckte elektrische Schaltungen die Funktion der Isolierung zufällt, kann in weiten Bereichen variiert werden. Die bevorzugten Verfahren zur Herstellung der erfindungsgemäßen Laminate, die unten beschrieben werden, gestatten nämlich auch die Erzeugung von Laminaten mit relativ dicken Schichten dieser Polyimide, die die hohen Anforderungen an diese Laminate erfüllen. Bevorzugt liegt die Dicke jeder Schicht aus nicht mehr formbarem Polyimid im Bereich zwischen 1 µm und 1 mm. Beim Einsatz der erfindungsgemäßen Laminate für übliche gedruckte Schaltkreise im Bereich der Elektronik haben sich Schichtdicken für die nicht mehr formbaren Polyimide von 10 µm bis 1 mm, insbesondere von 50 bis 250 µm als besonders geeignet erwiesen.

In einer weiteren bevorzugten Ausführungsform sind alle Schichten aus nicht mehr formbarem Polyimid gleich dick. Dieser Fall tritt u.a. dann auf, wenn es sich um Mehrfachlaminate handelt, die aus identischen single clads einheitlicher Qualität hergestellt werden.

Eine bevorzugte Ausführungsform der Laminate besteht darin, daß als Trägermaterial eine Folie aus einem Metall oder einer Metallegierung und/oder eine Polymerfolie und/oder ein Flächengebilde aus einem Fasermaterial verwendet wird.

Als Polymerfolien kommen hierbei beispielsweise Folien aus aromatischen Polyamiden oder Polyimiden in Betracht, als Fasermaterialien für Flächengebilde metallfasern, synthetische Fasern z.B. aus aromatischen Polyamiden, und mineralische Fasern wie Glasfasern, Quarz- oder Asbestfasern oder Kohlenstoffasern.

Besonders bevorzugt Trägermaterialien, speziell im Hinblick auf die Verwendung der Laminate für gedruckte elektrische Schaltungen, sind Folien aus Kupfer, Nickel, Aluminium, oder Folien aus einer Legierung, welche eines oder mehrere dieser Metalle als wesentlichen Bestandteil enthält, wie z.B. einer Chrom/Nickel-Legierung. Auch Folien aus Stahl haben sich als sehr geeignet erwiesen. In einer speziellen Ausführungsform besteht das Trägermaterial in einer Folie aus gewalztem, getempertem Kupfer oder einer gewalzten, getemperten Kupferlegierung. Daneben besteht eine bevorzugte Ausführungsform des erfingungsgemäßen Verfahrens darin, daß als Trägermaterial eine Folie aus amorphem metall verwendet wird. Hierdurch lassen sich spezielle Eigenschaften der Laminate erzielen. Diese werden hervorgerufen durch die amorphen Metalle. Diese amorphen Metalle weisen nicht die bei Metallen üblichen Kristallstrukturen auf. Sie werden deshalb auch als "metallische Gläser" bezeichnet. Sie können hergestellt werden durch Abschrecken von Metallschmelzen oder von Schmelzen von Legierungen. Für die erfindungsgemäßen Laminate als Trägermaterial geeignete amorphe metalle sind z.B. amorphe

Legierungen, die Eisen enthalten. Weitere geeignete amorphe Metalle sind in dem Artikel in *"Spektrum der Wissenschaft" Juni 1980, S. 46* beschrieben.

Die Schichtdicke der als Trägermaterial dienenden Folie(n) beträgt für den Fall, daß es sich um Metall- bzw. Legierungsfolien handelt, bevorzugt 5 bis 110 und in einer weiter bevorzugten Ausführungsform 10 bis 50 μm.

In einer vorteilhaften Ausführungsform der erfindungsgemäßen Laminate enthält die Schicht bzw. enthalten die Schichten aus heißsiegelbarem Hochtemperaturklebstoff ein Fasermaterial. Dieses dient der Verstärkung. Als Fasermaterialien kommen besonders temperaturstabile Glasfasern (Natrium-Aluminiumsilikatfasern), Aramidfasern (Fasern aus aromatischen Polyamiden), Kohlenstoffasern und/oder Kieselsäure ($SiO_2 \cdot nH_2O$)-fasern in Frage. Bevorzugt liegen diese Fasern als Gewebe aus Endlosfilamenten vor. Die Fasern können ggf. jedoch auch als Vlies oder als lose Stapelfasern eingesetzt werden.

Der Einsatz von Verstärkungsfasern ist natürlich nur oberhalb eines Mindestverhältnisses von Klebstoffschichtdicke zu Faser- bzw. Gewebedurchmesser möglich bzw. sinnvoll.

In manchen Fällen hat es sich als vorteilhaft erwiesen, wenn mindestens eine Polyimidschicht und/ oder die Schicht aus Hochtemperaturklebstoff Teilchen aus Polytetrafluoräthylen (PTFE) enthält. Die PTFE-Teilchen wirken als Verstärkung und/oder sie verbessern die elektrischen, d.h. isolierenden Eigenschaften.

Die erfingungsgemäßen Laminate lassen sich nach einem Verfahren herstellen, das gekennzeichnet ist durch die in Anspruch 21 angegebenen Maßnahmen.

Der erste Schritt des Verfahrens besteht somit in der Herstellung von single clads aus einem Trägermaterial und einem direkt mit dem Trägermaterial verbundenen, nicht mehr formbaren vollaromatischen Polyimid.

Dieser erste Verfahrensabschnitt wird nunmehr beschrieben.

Die Herstellung der Polyamidsäure erfolgt durch Umsetzung einer aromatischen Tetracarbonsäure, vorzugsweise Pyromellitsäure oder vorzugsweise ihres Dianhydrids, Pyromellitsäuredianhydrid (PMDA) mit einem primären aromatischen Diamin, bevorzugt ist 4,4'-Diaminodiphenyläther (DADE), in einem Lösungsmittel, zum Beispiel Dimethylacetamid (DMAc). Zum single clad gelangt man durch Aufbringen eines Films der Polyamidsäurelösung auf ein Trägermaterial, wie eine Metallfolie oder ein Polymermaterial oder ein Flächengebilde aus Fasermaterial und Aushärtung des Films in situ durch Hitzebehandlung in mindestens zwei Stufen, so daß man ein single clad erhält, dessen Polyimidschicht fest an dem genannten Trägermaterial haftet, ohne daß für die Verbindung der Polyimidfolie mit dem Substrat der Einsatz einer verklebenden Zwischenschicht erforderlich ist.

Bei dem single clad kann es sich um ein Flächengebilde, das heißt eine flexible Polyimidschicht handeln, die an einer Folie aus Kupfer oder einem anderen metallischen Material, zum Beispiel Aluminium, Nickel oder Stahl oder einer Legierung, welche eines oder mehrere der genannten Metalle als wesentlichen Bestandteil enthält oder an einer Folie aus amorphem Metall haftet. In jedem Fall haftet die Polyimidschicht fest an dem Substrat und besitzt eine hohe Schälfestigkeit von 4,0 N/cm und mehr.

Als Trägermaterial können z.B. Werkstoffe aus metallischem material oder aus synthetischen Polymeren dienen. Im Fall metallischer Werkstoffe muß es sich nicht um das Metall als Element in reiner Form handeln. Es können insbesondere aus Trägermaterialien aus Metallegierungen eingesetzt werden wie Legierungen, die Nickel, Chrom und Eisen oder Nickel und Kupfer enthalten oder amorphe legierungen, die Eisen enthalten. Als besonders geeignete Trägermaterialien haben sich Folien aus gewalztem getempertem Kupfer oder aus einer gewalztem getemperten Kupferlegierung erwiesen. In manchen Fällen hat es sich als vorteilhaft erwiesen, das Trägermaterial vor der Beschichtung vorzubehandeln. Diese Vorbehandlung kann in eine chemischen Behandlung, z.B. Einwirkung einer sauren Salzlösung oder in einer mechanischen Aufrauhung bestehen. Es hat sich herausgestellt, daß sich durch diese Vorbehandlung einer weitere Erhöhung der Haftung der Polyimidschicht und damit eine Erhöhung der Schälfestigkeit erzielen läßt. Die chemische Vorbehandlung kann neben einer Aufrauhung der Oberfläche zur Ausbildung von Metalloxidgruppen an der zu beschichtenden Oberfläche des Trägermaterials führen, wodurch ggf. die Haftung eines metallischen Trägermaterials an der Polyimidschicht weiter erhöht werden kann. Als günstig hat es sich erwiesen, die Vorbehandlung so durchzuführen, daß ein Mittenrauhwert ($R_a$) von mindestens 0,2 μm erhalten wird.

Um zu den single clads zu gelangen, setzt man ein primäres aromatisches Diamin mit einer aromatischen Tetracarbonsäure oder ihrem Dianhydrid unter Bedingungen, die zur Bilding einer Lösung von Polyamidsäure in einem Lösungsmittel führen, um, in einer Ausführungsform der Erfindung in einem Extruder. Anschließend kann die Extrusion einer Schicht der Polyamidsäurelösung direkt auf das Substrat erfolgen, wobei anschließend das Lösungsmittel in situ zunächst in einer ersten Heizzone weitgehend aus der Polyamidsäureschicht entfernt und die Polyamidsäureschicht dann in situ durch eine weitere Hitzebehandlung in mindestens einer zweiten Heizzone bei einer höheren, zu praktisch vollständiger Imidisierung führenden Temperatur ausgehärtet wird. Anstatt die Polyamidsäurelösung durch Extrudieren auf das Trägermaterial aufzubringen, kann sie auch durch Aufrakeln aufgebracht werden. Die anschließende Temperaturbehandlung, die zur Entfernung des Lösungsmittels und zur Bilding des Polyimids führt, ist die gleiche wie oben angegeben. Eine Polyimidschicht von mehr als 10 μm zu erhalten, die keine Unterbrechungen oder Fehler aufgrund von Blasen enthält, die hervorgerufen sind durch Zusammenwirken eines Hauteffektes und einer zu raschen Verdampfung des Lösungsmittels oder des bei der Imidisierung oder Aushärtung entstehenden Wasserdampfes und die fest an dem Substrat haftet,

gelingt durch eine besondere Folge von Hitzebehandlungen.

Die bei der Erfindung verwendeten, durch Umsetzung einer aromatischen Tetracarbonsäure oder ihres Dianhydrids mit einem primären aromatischen Diamin in einem polaren organischen Lösungsmittel erhaltenen Polyamidsäurevorprodukte besitzen folgende Strukturformel:

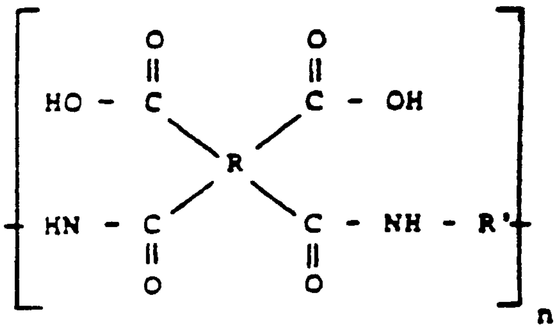

wobei

R einen aromatischen vierwertigen Rest und

R' einen zweiwertigen aromatischen Rest darstellen und

n ausreicht zur Bildung einer Polyamidsäure mit einer reduzierten Viskosität von 0,5 oder höher, gemessen als 0,5% ige Lösung in 0,1 Mol/Liter Lithiumbromid enthaltendem Dimethylacetamid. Die Polyamidsäure wird nach dem Aufbringen auf das Substrat nach dem offenbarten Erhitzungsverfahren ausgehärtet, wobei ein nicht mehr formbares, in Phenol bzw. phenolartigen Lösungsmitteln unlösliches Polyimid mit der folgenden sich weiderholenden Struktur entsteht:

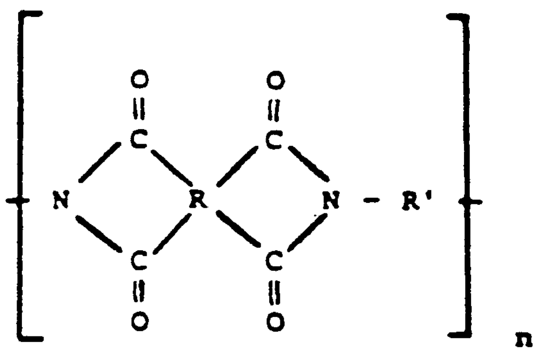

in der R und R' gleiche Reste darstellen, wie sie zuvor beschrieben worden sind.

Bei der Herstellung der Polyamidsäure werden als Ausgangsmaterialien vorzugsweise Pyromellitsäuredianhydrid und 4,4'-Diaminodiphenyläther und als Lösungsmittel vorzugsweise Dimethylacetamid verwendet.

Nach dem erfindungsgemäßen Verfahren können zur Herstellung der single clads auch andere Reaktionspartner extrudiert werden, die in herkömmlichen phenolischen Lösungsmitteln, z.B. Phenol oder substituierten Phenolen (halogenierten Phenolen), unlösliche, nicht mehr formbare Polyimide bilden.

Obwohl als Lösungsmittel vorzugsweise Dimethylacetamid (DMAc) verwendet wird, können auch andere polare organische Lösungsmittel, zum Beispiel N,N-Dimethyl-methoxyacetamid, Dimethylformamid (DMF); Diäthylformamid: N-Methyl-2-Pyrrolidon (NMP) und Dimethylsulfoxyd (DMSO) eingesetzt werden. Als weitere Lösungsmittel können zum Beispiel N-Methylcaprolactam, Dimethylsulfon, Pyridin, Hexamethylphosphoramid, N-Acetyl-2-Pyrrolidon, Tetramethylharnstoff und Tetramethylensulfon verwendet werden.

Die Herstellung der Polyamidsäure kann gemäß dem Stand der Technik, wie er beispielsweise in den US-Patentschriften *3 179 614* und *3 179 634* beschrieben ist, erfolgen.

In der Abbildung 1 wird eine bevorzugte Vorrichtung zur Durchführung des ersten Abschnitts des erfindungsgemäßen Verfahrens schematisch dargestellt. Abbildung 2 stellt den Querschnitt des Kondensations- bzw. Aushärtungsofens entlang der Linie 2—2 dar.

In der in Abb. 1 dargestellten Vorrichtung wird z.B. aus dem Dianhydrid und dem Diamin eine trockene Mischung mit einem Molverhältnis: Pyromellitsaüredianhydrid (PMDA): 4,4'-Diaminodiphenyläther (DADE) zwischen 0,95: 1 und 1,05: 1 hergestellt. Diese Mischung wird einer gravimetrischen Dosiervorrichtung 3 zugeführt. Dann wird die Mischung mit genau gesteuerter Geschwindigkeit in ein Extruder-Reaktionsgefäß 4 eingespeist. Mit Hilfe einer Dosierpumpe 5 wird der in dem Extruderreaktionsgefäß 4 befindlichen trockenen Mischung ein polares Lösungsmittel zugesetzt. Das Molekeulargewicht, der Polyamidsäure wird durch das Moverhältnis von Dianhydrid zu Diamin bestimmt. Den optimalen Molekulargewichtsbereich der Polamidsäure erreicht man bei einem Molverhältnis

zwischen 0,98 und 1,02 und er wird als reduzierte Viskosität ($\eta_{red}$) einer 0,5%igen Lösung in 0,1 Mol/liter Lithiumbromid enthaltendem Dimethylacetamid gemessen. Die reduzierte Viskosität der Polyamidsäure beträgt bei molaren Verhältnissen von 0,95 und 1,05 PMDA: DADE etwa 0,5 und liegt beim optimalen Verhältnis (zwischen 0,98 bis 1,02 PMDA: DADE) zwischen ca. 1,0 und 4,0. Bei einem molaren Verhältnis von 0,95 wurde ein durchschnittliches Molekulargewicht der gebildeten Polamidsäure von 32 000 gefunden, bei 1,0 ca. 200 000, bei 1,03 ca. 35 000 (Bestimmung mit einem FIKA-Lichtstreuungsphotometer, Modell PGD 42 000 bei $\lambda$ = 436 nm).

Die Temperatur im Extruderreaktionsgefäß 4 sollte auf einem Niveau unter ca. 80°C gehalten werden; in der Praxis kann sie jedoch allmählich von ca. 20°C ausgehend gesteigert oder in Zonen mit ansteigender Temperatur auf maximal 80°C angehoben werden. Das Lösungsmittel wird in der ersten Zone des Extruderreaktionsgefäßes 4 zugesetzt. Die Verweilzeit im Extruderreaktionsgefäß 4 liegt im Bereich von 1 bis 5 Minuten.

Am Ende dieser Verweilzeit ist die Reaktion zur Bildung der Polyamidsäure abgeschlossen. Die Polyamidsäure mit einer reduzierten Viskosität von 0,5 bis 4,0, vorzugsweise mehr als 1,0 kann dann durch eine Schlitzdüse 6 auf ein Trägermaterial 7, bei dem es sich um eine von einer Spule oder Rolle 8 abgezogene Folie aus Kupfer oder einem anderen Metall oder aus einer Legierung oder um eine synthetische Folie oder um eine Flächengebilde aus einem Fasermaterial handeln kann, extrudiert werden.

Das mit der Polyamidsäurelösung beschichtete Substrat läuft dann 5 bis 20 Minuten oder länger zwecks Kondensation zum Polyimid durch einen Ofen 10, dem mittels einer Versorgungsleitung 11 Stickstoff zugespeist wird. Die Durchlaufzeit hängt von der Filmdicke ab, da bei erhöherter Dicke längere Zeiten erforderlich sind.

Es hat sich als wesentlich erwiesen, die Temperaturen in aufeinanderfolgenden Zonen im Ofen zu steurn; wenn jedoch diese Steuerung innerhalb des genannten Bereiches erfolgt, bildet sich in sehr kurzer Zeit auf dem Substrat 7 eine nicht mehr formbare, blasenfreie Polyimidschicht mit ausgezeichneten elektrischen und mechanischen Eigenschaften, die an dem Substrat mit einer Schälfestigkeit von über 4,0 N/cm haftet. Ohne Beschränkung auf eine theoretische Erläuterung dieses Ergebnisses ist anzunehmen, daß es erforderlich ist, daß das Lösungsmittel so langsam durch die Polyamidsäureschicht diffundiert und von der freiliegenden Schichtoberfläche freigesetzt wird, daß sich keine Lösungsmittelblasen bilden können, die sich vergrößern und in der Polymerschicht-Matrix eingechlossen bleiben. Auch muß ein Großteil des Lösungsmittels von der freiliegenden Seite der Polyamidsäureschicht freigesetzt werden, bevor die Imidisierung abgeschlossen ist. Ferner muß die Imidisierungsreaktion zu 80 bis 90% bei Temperaturen unter ca. 180°C abgeschlossen werden, so daß auch der größere Teil des bei der Cyclisierungsreaktion gebildeten Wassers an die Schichtoberfläche diffundiert und freigesetzt wird.

Um das vorstehende Ziel zu erreichen, sind im der Kondensation dienenden Ofen mittels, Widerstandselementen 12, 13, 14 und 15 folgende Heizzonen vorgesehen:

In der ersten Zone wird die Temperatur mit einem elektrischen Widerstandselement 12 im Bereich von 100 bis 150°C gehalten; in der zweiten Zone wird die Temperatur auf ca. 130°C bis ca. 200°C, vorzugsweise unterhalb 180°C angehoben; in der dritten Zone wird die Temperatur auf ca. 200 bis 400°C erhöht, nachdem im wesentlichen das gesamte Lösungsmittel zur Oberfläche diffundiert und entfernt und auch der größte Teil des bei der Cyclisierungsreaktion gebildeten Wassers entfernt ist; in der vierten Zone wird die Temperatur nochmals, vorzugsweise auf ca. 300 bis 600°C, angehoben. Jede dieser Zonen ist ungefähr gleich lang und daher ist auch die Verweilzeit in den einzelnen Zonen ungefähr gleich. Man kann jedoch die Geschwindigkeit des Durchlaufs und somit den Durchsatz erhöhen, indem man die erste und/oder zweite Zone verlängert oder der ersten Zone eine zusätzliche Heizzone vorschaltet, die man bei einer Temperatur von über 50°C, jedoch unter der Temperatur der ersten Zone, hält. Bei der in Abbildung 2 gezeigten Vorrichtung kann der Ofen 10 mit beweglichem Deckel 16 versehen sein, um einen leichten Zugang zum Schichtkörper im Ofen zu schaffen.

In einem zweiten Verfahrensabschnitt wird ein heißsiegelbarer Hochtemperaturklebstoff der aus der Klasse der Acrylate, Polysulfonharze, Epoxiharze, Fluorpolymerharze, Silikonharze oder Butylkautschuke ausgewählt ist, auf die dem Trägermaterial abgewandte Seite der Schicht aus nicht mehr formbarem Polyimid aufgebracht. Der Klebstoff kann hierbei aus einer Lösung aufgebracht werden, wobei anschließend das Lösungsmittel durch Ehitzen entfernt wird. Der Klebstoff kann jedoch auch in einer bevorzugten Ausführungsform als Folie aufgebracht werden. Anschließend an das Aufbringen der Folie werden zwei single clads mit Hilfe der Folie zu einem double clad mit dem Aufbau Trägermaterial/Polyimid/Klebstoff/Polyimid/Trägermaterial versiegelt.

Single clads (von denen mindestens eines eine Schicht aus Klebstoff aufweist), können auf verschiedene Weise zu erfindungsgemäßen Laminaten weiterverarbeitet werden:

a) Man verbindet zwei gleiche oder verschiedene single clads jeweils an ihren freiliegenden Oberflächen aus heißsiegelbarem Hocktemperaturklebstoff zu einem double clad. Dies geschieht bei einer Temperatur im Bereich von 140 bis 500°C und ggf. unter Anwendung von Druck. Ein bevorzugter Temperaturbereich liegt hierbei zwischen 180 und 450°C. Die beiden hierfür verwendeten single clads können sich in der Natur des Trägermaterials und/oder des nicht mehr formbaren Polyimids und/oder des heißsiegelbaren Klebstoffs und/oder in den Dicken der einzelnen Schichten unterscheiden. Je nach der Natur der beiden heißsiegelbaren Klebstoffe und/oder den Verfahrensbedingungen (Temperatur, Druck) entstehen dabei double clads, in denen noch zwei definierte Schichten aus hießsiegelbaren Klebstoffen

nachweisbar sind oder double clads, in denen die ursprünglich getrennten Schichten aus heißsiegelbaren Klebstoffen nur noch eine definierte Schicht ergeben. Bei der hier beschriebenen Verfahrensvariante wird also der heißsiegelbare Hocktemperaturklebstoff auf beide der zu verbindenden Schichten aufgebracht.

b) Man verbindet ein single clad, das eine Klebstoffschicht aufweist mit einem single clad, das nach dem ersten Verfahrensschritt erhalten wird, das also nur aus Trägermaterial und nicht mehr formbarem Polyimid besteht. Hierbei wird die Schicht aus heißsiegelbarem Klebstoff des erstgenannten single clads mit der Schicht aus nicht mehr formbarem Polyimid eines signle clads verbunden, wiederrum bei den unter a) genannten Temperaturen und ggf. unter Druck. Es entstehen Produkte, die den unter a) als zweite Möglichkeit genannten (nur eine definierte Schicht aus heißsiegelbarem Klebstoff) entspechen. Bei dieser Verfahrensvariante wird also die Schicht aus heißsiegelbarem Klebstoff nur auf eine der zu verbindenden Schichten aufgebracht.

c) Ausgehend von den Produkten, die nach den beschriebenen Verfahrensvarianten hergestellt wurden, können ggf. weitere Schichten auf die freiliegenden Außenflächen angebracht werden, um Mehrfach-clads zu erhalten.

Das Verbinden des single clads mit anderen Schichten geschieht bei einer Temperatur, bei welcher der verwendete heißsiegelbare Hocktemperaturklebstoff formbar ist. Je nach der Art der zu verbindenden Schichten, der Art des heißsiegelbaren Klebstoffs sowie der gewünschten Laminateigenschaften kann das Verbinden durch Anwendung eines leichten oder höheren Drucks geschehen. Gegebenenfalls kann der Klebstoff bereits vor vollständiger Aushärtung des Polyimids aufegebracht werden, wodurch unter Umständen die Haftung des Polyimids am Klebstoff verbessert werden kann. Anschließend wird dann die Aushärtung zum nicht mehr formbaren Polyimid vorgenommen.

Im Anschluß an die beschriebenen Verfahrensschritte, die zu den erfindungsgemäßen Laminaten führen, können, falls gewünscht, weitere Schichten aufgebracht werden. Nach einer weiteren Ausführungsform des Verfahrens lassen sich die oben beschriebenen Laminate herstellen, bei denen beide Seiten einer oder beider Schichten aus Trägermaterial direkt mit nicht mehr formbarem Polyimid verbunden sind. Hierzu stellt man nach dem beschriebenen ersten Verfahrensschritt zuerst ein single clad aus Trägermaterial und Polyimid her und härtet das Polyimid vollständig aus. Anschließend wird die zweite Seite des Trägermaterials mit einer Polyamidsäurelösung, die zu einem nicht mehr formbaren Polyimid führt, beschichtet und das Lösungsmittel verdampft. Anschließend kann direkt vollständig ausgehärtet oder vor dem vollständigen Aushärten der heißsiegelbare Klebstoff aufgebracht werden.

Anschließend kann wie beschrieben vorgegangen werden, um zu erfindungsgemäßen Laminaten zu gelangen. Die nach dieser Ausführungsform erhaltenen Laminate weisen somit eine Schichtstruktur mit folgender Reihenfolge auf:

nicht mehr formbares Polyimid-Trägermaterial — nicht mehr formbares Polyimid — heißsiegelbarer Hochtemperaturklebstoff/nicht mehr formbares Polyimid/Trägermaterial.

Die Erfindung wird nunmehr durch Ausführungsbeispiele veranschaulicht.

### Beispiele 1 bis 3

Diese Beispiele veranschaulichen den ersten Verfahrensabschnitt, der zu single clads führt, die nach den in den nachfolgenden Beispielen angegebenen Verfahrensvarianten zu den erfindungsgemäßen Laminaten weiterverarbeitet werden können.

### Beispiel 1

In einem handelsüblichen Pulvermischer wurde eine trockene Mischung aus Pyromellitsäuredianhydrid (PMDA) und 4,4'-Diaminodiphenyläther (DADE) hergestellt. Insgesamt wurden 5,0 kg PMDA und 4,54 kg DADE (molares Verhältnis PMDA: DADE 1,01) in den Mischer eingewogen und danach 48 Stunden auf der höchsten Geschwindigkeitsstufe gemischt. Anschließend wurden ca. 1,6 kg der Mischung in einer gravimetrische Dosiervorrichtung gegeben, welche die Mischung mit einer Geschwindigkeit von ca. 200 Gramm pro Stunde einem Doppelschneckenextruder mit negativer Einspeisung (negative-feed extruder) zuführte. In der ersten Extruderstufe, die bei 20°C gehalten wurde, wurde DMAc mit einer Geschwindigkeit von ca. 430 Gramm pro Stunde zugesetzt, so daß eine Feststoffkonzentration von 31,7 Gew.% erhalten wurde. Während der restlichen Verweilzeit im Extruder wurde die Temperatur in aufeinanderfolgenden Zonen auf 50°C erhöht. Dabei bildete sich eine Polyamidsäure mit einer reduzierten Viskosität von 1,67, die aus dem Extruderzylinder durch eine Düse für dünne Folien gepreßt wurde. Die Düsenöffnung hatte einen rechteckigen Querschnitt mit den Maßen 200 × 0,35 mm. Der Druck am Düsenkopf betrug 85 bar. Die Polyamidsäurelösung wurde auf eine 35 µm dicke Bahn aus gewalzter getemperter Kupferfolie (Oak F—111) extrudiert und das Laminat wurde dann in einen Ofen mit vier gleichlangen Temperaturzonen von 140°C, 180°C, 350°C und 400°C unter einer Stickstoffatmosphäre eingeleitet. Die Gesamtverweilzeit des Laminats betrug 10 Minuten. Während dieser Zeit wurde die Polyamidsäure praktisch vollkommen in das Polyimid umgesetzt. Die Polyimidfolie haftete fest an dem Kupfersubstrat und war frei von Blasen und Unterbrechungen.

Bei der vorgenannten Oak F—111-Kupferfolie handelt es sich um ein Produkt der Firma oak Materials Group Inc., USA das die Anforderungen der IPC—CF 150 E erfüllt.

Beispiel 2

Eine zweite 1,6-kg Probe der Mischung wurde der gleichen Behandlung wie im Beispiel 1 unterzogen, jedoch mit dem Unterschied, daß nunmehr eine 70 µm dicke Kupferfolie (Oak F—111) als Substrat diente. Der Polyimidfilm haftete fest an der Kupferfolie und war frei von Blasen und Unterbrechungen. Die Eigenschaften der Laminate aus den Beispielen 1 und 2 sind in der nachfolgenden Tabelle zusammengestellt.

TABELLE

| Eigenschaft (Polyimidschicht) | Beispiel 1 | Beispiel 2 | Prüfung |
|---|---|---|---|
| Durchschlagsfestigkeit, KV/$10^{-3}$ inch bei 60 Hz | 4,4 | 4,35 | ASTM D—149 |
| Dielektrizitätskonstante bei 1 KHz und 25°C | 4,0 | 3,9 | ASTM D—150 |
| Dielektrischer Verlustfaktor bei 1 KHz und 250°C | 0,0047 | 0,0039 | ASTM D—150 |
| Zugfestigkeit, N/$mm^2$ | 105 | 110 | ASTM D882 |
| Bruchdehnung, % | 45 | 31 | ASTM D882 |
| Dichte, g/$cm^3$ | 1,42 | 1,42 | ASTM D1505 |
| Dicke, µm | 66 | 61 | ASTM D374 |
| IOI | 40 | 40 | ASTM D2863 |
| Eigenschaft (Laminat) | | | |
| Schälfestigkeit, N/cm | 8,2 | 4,8 | IPC TM 650 2.4.9 |
| Verhalten beim Löten ohne weitere Vorbehandlung | keine Blassen-bildung kein Ablösen | keine Blassen-bildung kein Ablösen | IPC TM 650 2.4.13 (leicht modifiziert) |

Beispiel 3

Ein Dreihalskolben wird mit 8,17 g PMDA beschickt, dem 7,58 g DADE, gelöst in 60 g DMAc zugesetzt wird. Das DADE war vorher unter ständigem Rühren bei voller Geschwindigkeit in DMAc gelöst worden. Das Molverhältnis PMDA: DADE betrug 0,99: 1,00. Danach wurden in des Reaktionsgefäß weitere 29,25 g des DMAc gegeben, das vorher zum Ausspülen des Kolbens verwendet wurde, in dem DADE gelöst wurde. Die Reaktion wird 80 Minuten unter Rühren bei einer Temperatur von 22°C in einer Stickstoffatomosphäre fortgesetzt. Ein Teil der entstandenen Polyamidsäurelösung wird auf eine vorhar mit einer Eisen-III-chloridlösung aus 30 g $FeCl_3$, 60 $cm^3$ 12 n HCl und 180 $cm^3$ Wasser geätzte Nickel-Chrom-Folie einer Dicke von 23 µm (inconel der Fa. Somers Thin-Strip/Brass Group, Olin Corp. Waterbury, Connecticut) aufgegossen. Die Inconel-Folie bestand aus einer Legierung mit Nickel als Haptbestandteil sowie chrom und Eisen. Die aufgegossene Polyamidsäurelösung wird auf eine Dicke von 356 µm mit Hilfe eines Glasstabes, auf den Kupferdraht mit einem Durchmesser von 356 µm gewickelt ist, ausgezogen. Die Legierungsfolie wird auf eine Glasplatte aufgebracht und mit einem Klebestreifen befestigt. Der Film wird 20 Minuten bei 70°C getrocknet un dann in einem Vakuumtrockner, bei einem Unterdruck von ca. $2,66 \cdot 10^{-3}$ bar (2 mm Hg) bei 160°C in einer Stickstoffatmosphäre behandelt. Die Temperatur des Trockners wird dann innerhalb von 4 1/2 Stunden auf 310°C erhöht. Wenn der Film eine Temperatur von 160°C erreicht hat, was innerhalb von ca 1—2 Minuten der Fall ist, ist bereits der größte Teil des Lösungsmittels ausgetrieben, wie man an Hand der Farbe des Films, einem klaren, hellen Gelb, festellen kann. Der ausgrehärtete trockene Film besaß ene Dicke von 25 µm.

Daneben wurde eine gemäß Beispiel 1 erhaltene Polyamidsaüre-Probe auf 22 Gew.-% Polyamidsäure und eine reduzierte Viskosität ($\eta_{red}$) von 1,22 mit DMAc verdünnt und auf eine Legierungsfolie von 58 µm Dicke aus einer Kupfer-Nickel-Legierung mit ca. 70% Cu und ca. 30% Ni (Cupro-Nickel 30 # 715 von Somers Thin-Strip/Brass Group, Olin Corp., Waterbury, Connecticut) mit einer gerauhten ("machine scrubbed") Oberfläche aufgegossen und mit einer Rakel bis zu einer Naßfoliendicke von 356 µm verstrichen. Der aufgegossene Film wurde ebenfalls entsprechend der in diesem Beispiel angegebenen Methode getrocknet und ausgehärtet. Beide Filme besaßen eine extrem hohe Schälfestigkeit, während eine ähnliche Filmprobe, die sich auf einer glänzenden, unbehandelten Legierungsfolie befindet, sich leicht abschälen

läßt (Schälfestigkeit 0,7 N/cm). Weder die auf der geätzten noch die auf der aufgerauhten Folie befindliche Polyimidschicht ließ sich ohne Beschädigung der Polyimid-Folie abtrennen, um auf diese Weise dei Schälfestigkeit zu messen. Nach einer siebentägigen Behandlung bei 260°C wies der Polyimid-Film auf der gerauhten Folie eine ausgezeichnete Haftung und Geschmeidigkeit auf.

Beispiel 4

Zwei 10 × 20 cm große Einfachclads, aus 35 µm dicker, messingbeschichteter Kupferfolie (Gould) und Polyimid aus PMDA und DADE wurden mit Hilfe einer handelsüblichen 50 µm dicken Polyacrylat-Klebefolie laminiert, wobei die Schichtenfolge war: Kupferfolie, Polyimid, Klebefolie, Polyimid, Kupferfolie. Zur Laminierung wurde in einer Plattenpresse zunächst mit einem Druck von ca. 49 bar (50 kp/cm²) kalt gepreßt, der Folienstapel bei diesem Druck innerhalb einer Stunde auf 200°C aufgeheizt, eine Stunde bei diesen Bedingungen gehalten und anschließend unter Druck abgekühlt.

Die beiden Einfachclads waren einwandfrei zu einem Doppelclad verklebt.

Eigenschaften des double clads gehen aus folgender Tabelle hervor, wobei jeweils drei Werte eingetragen sind, die such aus drei Versuchen ergaben:

| Gesamtschichtdicke (µm) | Dielektrizitätskonstante | dielektrischer Verlustfaktor (× $10^3$) |
|---|---|---|
| 98/97/98 | 3,7/3,8/3,9 | 37,2/41,6/45,5 |

Die Versuche wurden wiederholt, wobei eine Polyacrylatfolie verwendet wurde, in die ein Gewebe eingelagert war. Dabei ergabe sich folgende Werte:

| | Gesamtschicht-dicke (µm) | Dielektrizitäts-konstante | dielektrischer Verlustfaktor (× $10^3$) |
|---|---|---|---|
| a) double clad | 160/163 | 3,8/3,9 | 29/30 |
| b) Klebefolie allein Vergleich | 115/115 | 5,1/5,6 | 95/117 |
| c) Vergleich* | 120/112/112 | 5,9/5,4/5,0 | 67,5/72,7/63,3 |

* Klebefolie direkt zwischen 2 Kupferfolien (ohne Polyimid) laminiert Die hier verwendete Polyacrylatfolie wurde von der Fa. Brand Rex Co. USA bezogen. Sie enthielt ein Glasfasergewebe in lockerer Leinwandbindung. Die Dicke der Einzelfasern des Gewebes betrug ca. 5 µm.

Die Ergebnisse zeigen, daß clads, bei denen eine Schicht aus Acrylat direkt mit Kupfer verbunden ist (Fall c) den erfindungsgemäßen Laminaten (Fall a), bei denen sich zwischen Acrylat und Kupfer jeweils eine Polyimidschicht befindet, bezüglich ihrer elektrischen Eigenschaften klar unterlegen sind.

Beispiel 5

Zwei 10 × 20 cm große Einfachclads derselben Spezifikation wie in Beispiel 4 wurden 2 h lang bei 200°C in Stickstoffatmosphäre getrocknet und anschließend mit Hilfe einer 100 µm dicken, zwischenliegenden Hostaflon®-TFA-Klebefolie (Fluorpolymeres, Hersteller: Fa. Hoechst, Franktfurt) in einer Plattenpresse laminiert. Hierbei waren die Polyimidschichten der Einfachclads in Kontakt mit der Klebefolie. Die Laminierungsbedingungen sind in folgender Tabelle angegeben.

TABELLE

| Laminierungsdauer | -temperatur | -druck |
|---|---|---|
| 1h | 340°C | ca. 20—30 bar (20—30 kp/cm²) |
| 1h | 370°C | ca. 30—60 bar (20—30 kp/cm²) |

Die Schälfestigkeit der Doppelclads betrug im Mittel bei dem bei 340°C laminierten Muster 7,0 N/cm zwischen Polyimid und Hostaflon und 6,0 N/cm zwischen Polyimid und Kupfer.

Der dielektrische Verlustfaktor von ca. 75 µm dicken clads betrug (3 nach obiger Methode hergestellte Proben) $14{,}0 \cdot 10^{-3}$ bzw. $16{,}2 \cdot 10^{-3}$ bzw. $16{,}6 \cdot 10^{-3}$, die entsprechenden Dielektrizitätskonstanten betrungen 2,8 bzw. 2,9 bzw. 2,8.

In den vorangegangenen Beispielen wurden folgende Abkuřzungen benutzt:

PMDA — Pyromellitsäuredianhydrid
DADE = 4,4'-Diaminodiphenyläther
DMAc = N,N-Dimethylactamid

**Patentansprüche**

1. Flexibles Mehrschicht-Laminat, welches ein single clad aus einer Schicht aus nicht mehr formbarem vollaromatischen Polyimid und einer Schicht aus Trägermaterial enthält, wobei die Schicht aus nicht mehr formbarem Polyimid an einer Seite direkt an der Schicht aus Trägermaterial mit einer Schälfestigkeit von mindestens 4,0 N/cm haftet, wobei das nicht mehr formbare Polyimid in phenolischen Lösungsmitteln unlöslich ist und die Schicht aus nicht mehr formbarem Polyimid eine Zugfestigkeit von 100 bis 150 $N/mm^2$, eine Bruchdehnung von 15—100% und einen dielektrischen Verlustfaktor von $1,5 \times 10^{-3}$ bis $5 \times 10^{-3}$ bei 1 kHz aufweist, dadurch gekennzeichnet, daß zwei solcher single clads über die den Trägermaterialien abgewandten Seiten der beiden Polyimidschichten mittels einer Schicht aus heißsiegelbarem Hochtemperaturklebstoff, er aus der Klasse der Polyacrylate, Polysulfonharze, Epoxiharze, Fluoropolymerharze, Silikonharze oder Butylkautschuke ausgewählt ist, miteinander verbunden sind.

2. Laminat nach Anspruch 1, dadurch gekennzeichnet, daß mindestens eines Schicht aus Trägermaterial auf beiden Seiten mit je einer Schicht aus nicht mehr formbarem, vollaromatischem Polyimid direkt verbunden ist.

3. Laminat nach Anspruch 1 oder 2, dadurch gekennzeichnet, daß die Dicke jeder Schicht aus Polyimid 1 µm bis 1 mm beträgt.

4. Laminat nach Anspruch 3, dadurch gekennzeichnet, daß die Dicke jeder Schicht aus Polyimid 10 µm—1 mm beträgt.

5. Laminat nach Anspruch 3, dadurch gekennzeichnet, daß die Dicke jeder Schicht aus Polyimid 50—250 µm beträgt.

6. Laminant nach einem oder mehreren der Ansprüche 1 bis 5, dadurch gekennzeichnet, daß alle Schichten aus Polyimid die gleiche Dicke aufweisen.

7. Laminat nach einem oder mehreren der Ansprüche 1 bis 6, dadurch gekennzeichnet, daß eine oder mehrere der Schichten aus Polyimid aus einem Polyimid besteht bzw. bestehen, das die folgende, sich wiederholende Struktur aufweist:

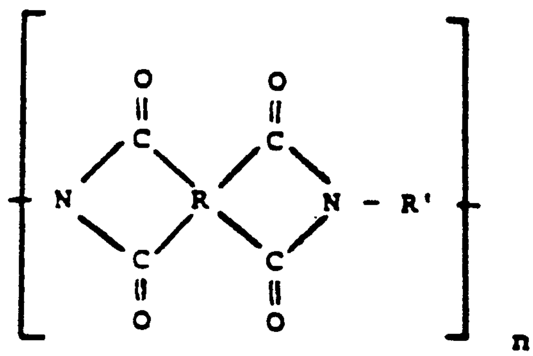

wobei
R ein vierwertiger aromatischer Rest
R' ein zweiwertiger aromatischer Rest ist.

8. Laminat nach Anspruch 7, dadurch gekennzeichnet, daß

R 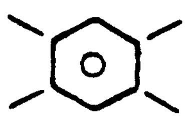 und R' 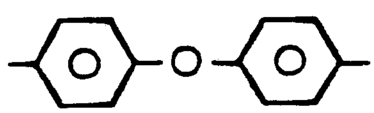

darstellen.

9. Laminat nach einem oder mehreren der Ansprüche 1 bis 8, dadurch gekennzeichnet, daß das Trägermaterial eine Folie aus einem Metall oder einer Metallegierung und/oder eine Polymerfolie und/oder ein Flächengebilde aus einem Fasermaterial ist.

10. Laminat nach Anspruch 9, dadurch gekennzeichnet, daß Trägermaterial eine Folie aus Kupfer, Nickel, Aluminium oder einer Legierung, welche eines oder mehrere dieser Metalle als wesentlichen Bestandteil enthält, oder eine Folie aus amorphem Metall oder eine Folie aus Stahl ist.

11. Laminat nach Anspruch 10, dadurch gekennzeichnet, daß die Folie aus gewalztem, getempertem Kupfer oder aus einer gewalzten, getemperten Kupferlegierung besteht.

12. Laminat nach Anspruch 10 oder 11, dadurch gekennzeichnet, daß die Dicke der Folie 5—110 µ m beträgt.

13. Laminat nach Anspruch 12, dadurch gekennzeichnet, daß die Dicke der Folie 10 bis 50 μm beträgt.

14. Laminat nach einem oder mehreren der Ansprüche 1 bis 13, dadurch gekennzeichnet, daß der Hocktemperaturklebstoff Fasermaterial enthält.

15. Laminat nach Anspruch 14, dadurch gekennzeichnet, daß das Fasermaterial aus Glas-, Kieselsäure-, Aramid- und/oder Kohlenstoffaser besteht.

16. Laminat nach den Ansprüchen 14 oder 15, dadurch gekennzeichnet, daß das Fasermaterial ein Gewebe aus Endlosfilmantenten ist.

17. Laminat nach einem oder mehreren der Ansprüche 1 bis 16, dadurch gekennzeichnet, daß mindestens eine Schicht aus Polyimid und/oder die Schicht aus Hochtemperaturklebstoff Teilchen aus Polytetrafluoräthylen enthält.

18. Laminat nach einem oder mehreren der Ansprüche 1 bis 17 herstellbar dadurch, daß man eine Polyamidsäurelösung, die aus einer aromatischen Tetracarbonsäure oder deren Dianhydrid und einem primären aromatischen Diamin gebildet wird, auf ein Trägermaterial ohne Zwischenschicht aufbringt und und das beschiechtete Trägermaterial erhitzt, wobei man die aromatische Tetracarbonsäure oder deren Dianhydrid mit einem aromatischen Diamin im Molverhältnis von 0,95 : 1 bis 1,05 : 1 in einem polaren Lösungsmittel zu einer Polymerverbindung aus einer Polyamidsaüre mit der Formel

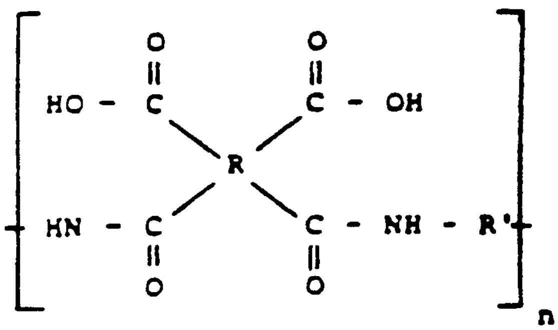

wobei

R einen aromatischen vierwertigen Rest und R' einen zweiwertigen aromatischen Rest darstellen und n ausreicht, um eine Polyamidsäure mit einem $\eta_{red}$-Wert von mindestens 0,5 zu erhalten, gemessan als 0,5%ige Lösung in 0,1 Mol/Liter Lithiumbromid enthaltendem Dimethylacetamid, umsetzt, aus der erhaltenen Polyamidsäurelösung auf dem Trägermaterial das Lösungsmittel in einer ersten Stufe, deren Temperatur im Bereich von 100 bis 200°C liegt, in situ entfernt, wobei im wesentlichen die gesamte Lösungsmittelmenge entfernt wird, un den Film in einer zweiten Stufe, bei der die Temperatur mehr als 200°C, vorzugsweise mehr als 300°C beträgt, in situ zu einem in phenolischen Lösungsmitteln unlöslichen, nicht mehr formbaren Polyimid aushärtet, wobei mindestens 95% der Polyamidsäure zu Polyimid umgesetzt werden, wodurch ein single clad erhalten wird, wobei man anschließend auf die dem Trägermaterial abgewandte Seite der Polyimidschicht einen heißsiegelbaren Hochtemperaturklebstoff, der aus der Klasse der Polyacrylate, Polysulfonharze, Epoxiharze, Fluorpolymerharze, Silikonharze oder Butylkautschuke ausgewählt ist, aufbringt und wobei man das so erhaltene Laminat mit einem zweiten single clad, das eine Schicht aus heißsiegelbarem Hocktemperaturklebstoff enthält, bei einer Temperatur im Bereich von 140 bis 500°C miteinander verbindet, wobei die Verbindung der Schichtkörper an den freiliegenden Seiten der Schichten aus Hochtemperaturklebstoff erfolgt.

19. Laminat nach Anspruch 18, dadurch gekennzeichnet, daß mindestens eines der Trägermaterialien eine Folie aus Kupfer, Nickel, Aluminium oder einer Legierung, welche eines oder mehrere dieser Metalle als wesentlichen Bestandteil enthält, oder eine Folie aus amorphem Metall oder eine Folie aus Stahl ist.

20. Laminat nach Anspruch 18 oder 19, dadurch gekennzeichnet, daß der Hocktemperaturklebstoff in Form einer Folie eingesetzt worden ist.

21. Verfahren zur Herstellung von Laminaten nach einem oder mehreren der Ansprüche 1 bis 17 dadurch gekennzeichnet, daß man eine Polyamidsäurelösung, die aus einer aromatischen Tetracarbonsäure oder deren Dianhydrid und einem primären aromatischen Diamin gebildet wird, auf ein Trägermaterial ohne Zwischenschicht aufbringt und das beschichtete Trägermaterial erhitzt, wobei man die aromatische Tetracarbonsäure oder deren Dianhydrid mit einem aromatischen Diamin im Molverhältnis von 0,95 : 1 bis 1,05 : 1 in einem polaren Lösungsmittel zu einer Polymerverbindung aus einer Polyamidsaüre mit der Formel

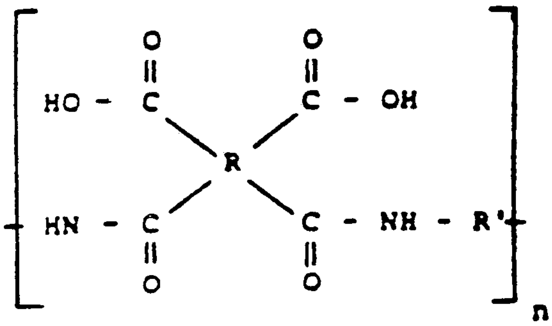

wobei

R einen aromatischen vierwertigen Rest und R' einen zweiwertigen aromatischen Rest darstellen und n ausreicht, um eine Polyamidsäure mit einem $\eta_{red}$-Wert von mindestens 0,5 zu erhalten, gemessan als 0,5%ige Lösung in 0,1 Mol/Liter Lithiumbromid enthaltendem Dimethylacetamid, umsetzt, aus der erhaltenen Polyamidsäurelösung auf dem Trägermatrial das Lösungsmittel in einer ersten Stufe, deren Temperatur im Bereich von 100 bis 200°C liegt, in situ entfernt, wobei im wesentlichen die gesamte Lösungsmittelmenge entfernt wird, und den Film in einer zweiten Stufe, bei der die Temperatur mehr als 200°C, vorzugsweise mehr als 300°C beträgt, in stiu zu einem in phenolischen Lösungsmitteln unlöslichen, nicht mehr formbaren Polyimid aushärtet, wobei mindestens 95% der Polyamidsäure zu Polyimid umgesetzt werden, wodurch ein single clad erhalten wird, wobei man auf die dem Trägermaterial abgewandte Seite der Polyimidschicht einen heißsiegelbaren Hochtemperaturklebstoff, der aus der Klasse der Polyacrylate, Polysulfonharze, Epoxiharze, Fluorpolymerharze, Silikonharze oder Butylkautschuke ausgewählt ist, aufbringt und wobei man das so erhaltene Laminat mit einem zweiten single clad, das eine Schicht aus heißsiegelbarem Hocktemperaturklebstoff enthält, bei einer Temperatur im Bereich von 140 bis 500°C miteinander verbindet, wobei die Verbindung der Schichtkörper an den freiliegenden Seiten der Schichten aus Hochtemperaturklebstoff erfolgt.

22. Verfahren zur Herstellung von Laminaten nach Anspruch 21, dadurch gekennzeichnet, daß man das mit der Polyamidsäurelösung beschichtete Trägermaterial kontinuierlich durch mindestens zwei Hiezzonen mit steigender Temperatur laufen läßt.

23. Verfahren zur Herstellung von Laminaten nach Anspruch 21 oder 22, dadurch gekennzeichnet, daß die Umsetzung der aromatischen Tetracarbonsäure oder ihres Dianhydrids mit dem aromatischen Diamin zur Polyamidsäurelosung in einem Extruder durchgeführt wird.

24. Verfahren zur Herstellung von Laminaten nach einem oder mehreren der Ansprüche 21 bis 23, dadurch gekennzeichnet, daß die Polyamidsäurelösung von einer Mischund Fördervorrichtung kontinuierlich dosiert und durch eine geformte Öffnung auf das Trägermaterial extrudiert wird.

25. Verfahren zur Herstellung von Laminaten nach einem oder mehreren der Ansprüche 21 bis 23, dadurch gekennzeichnet, daß die Polyamidsaürelosung durch Rakeln auf das Trägermaterial aufgebracht wird.

26. Verfahren zur Herstellung von Laminaten nach einem oder mehreren der Ansprüche 21 bis 25, dadurch gekennzeichnet, daß der Film in der zweiten Stufe auf eine Temperatur im Bereich von 300 bis 600°C erhitzt wird.

27. Verfahren zur Herstellung von Laminaten nach einem oder mehreren der Ansprüche 21 bis 26, dadurch gekennzeichnet, daß das polare organische Lösungsmittel eine aprotisches Lösungsmittel ist.

28. Verfahren zur Herstellung von Laminaten nach Anspruch 27, dadurch gekennzeichnet, daß das aprotische polare organische Lösungsmittel Dimethylacetamid, Dimethylformamid, N-Methyl-2-pyrrolidon und/oder Dimethylsulfoxid ist.

29. Verfahren zur Herstellung von Laminaten nach einem oder mehreren der Ansprüche 21 bis 28, dadurch gekennzeichnet, daß als Trägermaterial eine Folie aus einem Metall oder einer Metallegierung und/oder eine Polymerfolie und/oder ein Flächengebilde aus einem Fasermaterial verwendet wird.

30. Verfahren zur Herstellung von Laminaten nach Anspruch 29, dadurch gekennzeichnet, daß als Trägermaterial eine Folie aus Kupfer, Nickel, Aluminium oder einer Legierung, welche eines oder mehrere dieser Metalle als wesentlichen Bestandteil enthält, oder eine Folie aus amorphem Metall oder eine Folie aus Stahl verwendet wird.

31. Verfahren zur Herstellung von Laminaten nach Anspruch 30, dadurch gekennzeichnet, daß die Folie aus gewalztem, getempertem Kupfer oder aus einer gewalzten, getemperten Kupferlegierung besteht.

32. Verfahren zur Herstellung von Laminaten nach Anspruch 30 oder 31, dadurch gekennzeichnet, daß die mit der Polyamidsäurelösung zu beschichtend Oberfläche des Trägermaterials vorher mittels mechanischer und/oder chemischer Behandlung aufgerauht bzw. geätzt wurde.

33. Verfahren zur Herstellung von Laminaten nach Anspruch 32, dadurch gekennzeichnet, daß die chemische und/oder mechanische Vorbehandlung so durchgeführt wird, daß die zu beschichtende Oberfläche des Trägermaterials nach der Vorbehandlung einen Mittenrauhenwert von mindestens 0,20 µm.

34. Verfahren zur Herstellung von Laminaten nach einem oder mehreren der Ansprüche 21 bis 33, dadurch gekennzeichnet, daß der Hochtemperaturklebstoff in Form einer Folie eingesetzt wird.

**Revendications**

1. Stratifié multicouche flexible contenant un placage simple constitué d'une couche en polyimide totalement aromatique qui n'est plus formable et d'une couche en matériau support, dans lequel la couche en polyimide qui n'est plus formable adhère directement sur une face à la couche de matériau support avec une résistance à l'enlèvement d'au moins 4,0 N/cm, le polyimide qui n'est plus formable est insoluble dans les solvants phénoliques et la couche en polyimide qui n'est plus formable présente un résistance à la traction de 100 à 150 $N/mm^2$, un allongement à la rupture de 15 à 100% et un facteur de perte diélectrique de $1,5 \times 10^{-3}$ à $5 \times 10^{-3}$ à 1 kHz, caractérisé en ce que deux tels placages simples sont liés l'une l'autre, par les faces des deux couches de polyimide situées à l'opposé des matériaux supports, au moyen d'une couche en adhésif haute température thermo-soudable, qui est choisi parmi les classes des polyacrylates, des résines polysulfone, des résines époxy, des resines de polymère fluoré, des résines de silicone ou des caoutchoucs butyle.

2. Stratifié selon la revendication 1, caractérisé en ce qu'au moins une couche de matériau support est reliée des deux côtés directement avec à chaque fois une couche de polyimide totalement aromatique qui n'est plus formable.

3. Stratifié selon la revendication 1 ou 2, caractérisé en ce que l'épaisseur de chaque couche de polyimide atteint 1 µm à 1 mm.

4. Stratifié selon la revendication 3, caractérisé en ce que l'épaisseur de chaque couche de polyimide atteint 10 µm à 1 mm.

5. Stratifié selon la revendication 3, caractérisé en ce que l'épaisseur de chaque couche de polyimide atteint 50 à 250 µm.

6. Stratifié selon l'une ou plusieurs des revendications 1 à 5, caractérisé en ce que toutes les couches de polyimide présentent la même épaisseur.

7. Stratifié selon l'une ou plusieurs des revendications 1 à 6, caractérisé en ce qu'une ou plusieurs des couches de polyimide consiste(nt) en un polyimide qui présente la structure répétitive suivante:

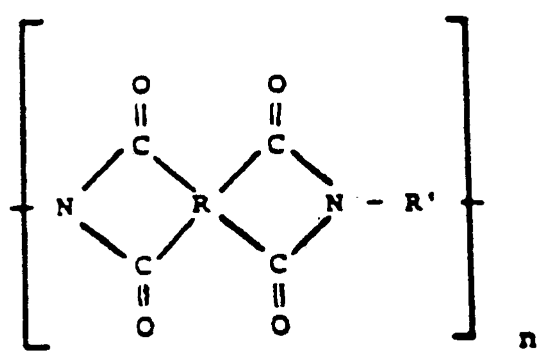

dans laquelle
R représente un reste aromatique tétravalent et
R' un reste aromatique divalent.

8. Stratifié selon la revendication 7, caractérisé en ce que R représente

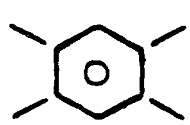

et R' représente

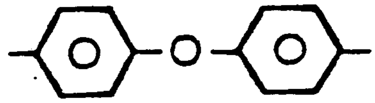

9. Stratifié selon l'une ou plusieurs des revendications 1 à 8, caractérisé en ce que le matériau support est une feuille en un métal ou un alliage métallique et/ou une feuille de polymère et/ou un produit en nappe constitué d'un matériau fibreux.

10. Stratifié selon la revendication 9, caractérisé en ce que le matériau support est une feuille en cuivre, nickel, aluminium ou en un alliage qui contient un ou plusieurs de ces métaux comme constituants essentiels, ou une feuille de métal amorphe ou une feuille d'acier.

11. Stratifié selon la revendication 10, caractérisé en ce que la feuille est constituée par du cuivre laminé recuit ou un alliage de cuivre laminé recuit.

12. Stratifié selon la revendication 10 ou 11, caractérisé en ce que l'épaisseur de la feuille atteint 5 à 110 µm.

13. Stratifié selon la revendication 12, caractérisé en ce que l'épaisseur de la feuille atteint 10 à 50 µm.

14. Stratifié selon l'une ou plusieurs des revendications 1 à 13, caractérisé en ce que l'adhésif haute température contient un matériau fibreux.

15. Stratifié selon la revendication 14, caractérisé en ce que le matériau fibreux consiste en des fibres de verre, fibres d'acide silicique, fibres d'aramide et/ou fibres de carbone.

16. Stratifié selon la revendication 14 ou 15, caractérisé en ce que le matériau fibreux est un tissu constitué de filaments sans fin.

17. Stratifié selon une ou plusieurs des revendications 1 à 16, caractérisé en ce qu'au moins une couche en polyimide et/ou la couche d'adhésif haute température contient des particules de polytétrafluoroéthylène.

18. Stratifié selon une ou plusieurs des revendications 1 à 17, préparable comme suit: on applique sans couche intermédiaire, sur un matériau support une solution de poly(amide acide) qui est formée à partir d'un acide tétracarboxylique aromatique ou son dianhydride et d'une diamine primaire aromatique, et chauffe le matériau support revêtu, l'acide tétracarboxylique aromatique ou son dianhydride étant mis à réagir avec une diamine aromatique, dans un rapport molaire de 0,95 : 1 à 1,05 : 1, dans un solvant polaire, pour l'obtention d'un composé polymère constitué d'un poly(amide acide) de formule

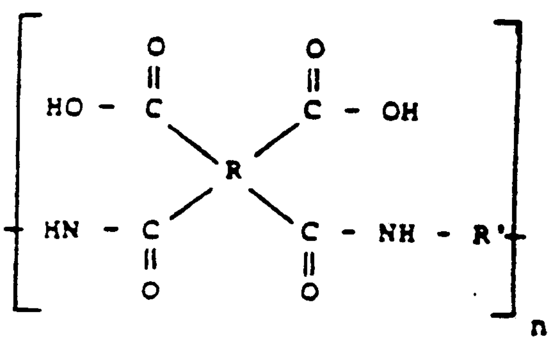

dans laquelle

R représente un reste aromatique tétravalent et

R' un reste aromatique divalent et

n est tel que le poly(amide acide) obtenu ait une valeur $\eta_{red}$, mesurée sur une solution à 0,5% dans du diméthylacétamide contenant 0,1 mole/litre de bromure de lithium, d'au moins 0,5, le solvant étant éliminé in situ de la solution de poly(amide acide) obtenue sur le matériau support dans une première étape réalisée à une température située dans l'intervalle allant de 100 à 200°C, étape lors de laquelle la totalité du solvant est pratiquement éliminée, et le film étant durci in situ en un polyimide insoluble dans les solvants phenoliques, qui n'est plus formable, dans une deuxième étape dans laquelle la température est supérieure à 200°C, de préférence supérieure à 300°C, étape lors de laquelle au moins 95% du poly(amide acide) est transformé en polyimide, ce qui permet d'obtenir un placage simple, on applique ensuite sur la face de la couche de polyimide, située à l'opposé du matériau support, un adhésif haute température thermo-soudable choisi parmi les classes des polyacrylates, résines polysulfone, résines époxy, résines de polymère fluoré, résines de silicone ou caoutchoucs butyle, et on lie le stratifié ainsi obtenu à une température située dans l'intervalle allant de 140 à 500°C, à un deuxième placage simple qui contient une couche d'adhésif haute température thermo-soudable, la liaison des pièces stratifiées ayant lieu par les faces libres des couches en adhèsif haute température.

19. Stratifié selon la revendication 18, caractérisé en ce qu'au moins l'un des matériaux supports est une feuille de cuivre, nickel, aluminium ou d'un alliage contenant un ou plusieurs de ces métaux comme constituant(s) essentiel(s), ou une feuille de métale amorphe ou une feuille d'acier.

20. Stratifié selon la revendication 18 ou 19, caractérisé en ce que l'adhésif haute température est utilise sous forme d'une feuille.

21. Procédé de préparation des stratifiés selon une ou plusieurs des revendications 1 à 17, caractérisé en ce que l'on applique, sans couche intermédiaire, sur un matériau support une solution de poly(amide acide) formée à partir d'un acide tétracarboxylique aromatique ou son dianhydride et d'une diamine aromatique primaire, et chauffe le matériau support revêtu, l'acide tétracarboxylique aromatique ou son dianhydride étant mis à réagir avec une diamine aromatique, dans un rapport molaire de 0,95: 1 à 1,05: 1, dans un solvant polaire, pour l'obtention d'un composé polymère constitué d'un poly(amide acide) de formule

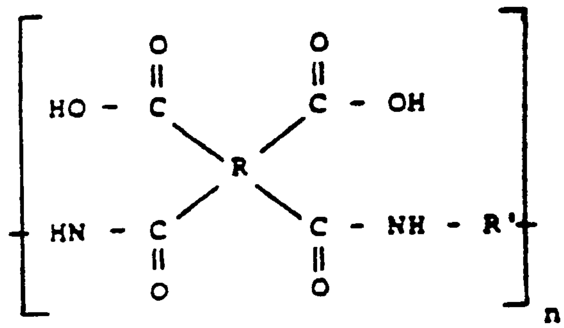

dans laquelle

R représente un reste aromatique tétravalent et

R' un reste aromatique divalent et

n est tel que le poly(amide acide) obtenu ait une valeur $\eta_{red}$, mesurée sur une solution à 0,5% dans du diméthylacétamide contenant 0,1 mole/litre de bromure de lithium, d'au moins 0,5, le solvant étant éliminé in situ de la solution de poly(amide acide) obtenue sur le matériau support dans une première étape réalisée à une température située dans l'intervalle allant de 100 à 200°C, étape lors de laquelle la totalité du solvant est pratiquement éliminée, et le film étant durci in situ en un polyimide insoluble dans les solvants phenoliques, qui n'est plus formable, dans une deuxième étape dans laquelle la température est supérieure à 200°C, de préférence supérieure à 300°C, étape lors de laquelle au moins 95% du poly(amide acide) est transformé en polyimide, ce qui permet d'obtenir un placage simple, on applique ensuite sur la face de la couche de polyimide, située à l'opposé du matériau support, un adhésif haute température thermo-soudable choisi parmi les classes des polyacrylates, résines polysulfone, résines époxy, résines de polymère fluoré, résines de silicone ou caoutchoucs butyle, et on lie le stratifié ainsi obtenu à une température située dans l'intervalle allant de 140 à 500°C, à un deuxième placage simple qui contient une couche d'adhésif haute température thermo-soudable, la liaison des pièces stratifiées ayant lieu par les côtés libres des couches en adhèsif haute température.

22. Procédé de préparation des stratifiés selon la revendication 21, caractérisé en ce que l'on fait traverser en continu au matériau support revêtu de la solution de poly(amide acide) au moins deux zones de chauffage de température croissante.

23. Procédé de préparation des stratifiés selon la revendication 21 ou 22, caractérisé en ce que la réaction de l'acide tétracarboxylique aromatique ou son dianhydride avec la diamine aromatique pour la formation de la solution de poly(amide acide) est effectuée dans une extrudeuse.

24. Procédé de préparation des stratifiés selon une ou plusieurs des revendications 21 à 23, caractérisé en ce que la solution de poly(amide acide) est introduite en continu de manière dosée par un dispositif de mélange et de transport et est extrudée sur le matériau support par une ouverture formée.

25. Procédé de préparation des stratifiés selon une ou plusieurs des revendications 21 à 23, caractérisé en ce que la solution de poly(amide acide) est appliquée par raclage sur le matériau support.

26. Procédé de préparation des stratifiés selon une ou plusieurs des revendications 21 à 25, caractérisé en ce que, dans la deuxième étape, le film est chauffé à une température située dans l'intervalle allant e 300 à 600°C.

27. Procédé de préparation des stratifiés selon une ou plusieurs des revendications 21 à 26, caractérisé en ce que le solvant organique polaire est un solvant aprotique.

28. Procédé de préparation des stratifiés selon la revendication 27, caractérisé en ce que le solvant organique polaire aprotique est le diméthylacétamide, le diméthylformamide, la N-méthyl-2-pyrrolidone et/ou le diméthylsulfoxyde.

29. Procédé de préparation des stratifiés selon une ou plusieurs des revendications 21 à 28, caractérisé en ce que l'on utilise comme matériau support une feuille d'une métal ou d'un alliage métallique et/ou une feuille de polymère et/ou un produit en nappe constitué d'un matériau fibreux.

30. Procédé de préparation des stratifiés selon la revendication 29, caractérisé en ce que l'on utilise, comme matériau support, une feuille de cuivre, nickel, aluminium ou d'un alliage contenant l'un ou plusieurs de ces métaux comme constituant(s) essentiel(s), ou une feuille de métal amorphe ou une feuille d'acier.

31. Procédé de préparation des stratifiés selon la revendication 30, caractérisé en ce que la feuille est en cuivre laminé recuit ou en un alliage de cuivre laminé recuit.

32. Procédé de préparation des stratifiés selon la revendication 30 ou 31, caractérisé en ce que la surface du matériau support à revêtir avec la solution de poly(amide acide) est au préalable rendue rugueuse ou décapée à l'aide d'un traitement mécanique et/ou chimique.

33. Procédé de préparation des stratifiés selon la revendication 32, caractérisé en ce que le prétraitement chimique et/ou mécanique est effectué de telle manière que la surface du matériau support à revêtir présente, après le prétraitement, un valeur de rugosité moyenne d'au moins 0,20 µm.

34. Procédé de préparation des stratifiés selon l'une ou plusieurs des revendications 21 à 33, caractérisé en ce que l'adhésif haute température est utilisé sous forme d'une feuille.

**Claims**

1. A flexible multilayer laminate comprising a single clad of a layer of no longer formable fully aromatic polyimide and a layer of support material, the layer of no longer formable polyimide adhering directly on one side to the layer of support material with a peel strength of at least on 4,0 N/cm, the no longer formable polyimide being insoluble in phenolic solvents and the layer of no longer formable polyimide having a tensile strength of 100 to 150 $N/mm^2$, an elongation at break of 15 to 100% and a dielectric loss factor of 1,5 $\times 10^{-3}$ to $5 \times 10^{-3}$ at 1 kHz, characterized in that two such single clads are joined to one another via the sides of the two polyimide layers remote from the support materials by means of a layer of heatsealable high-temperature adhesive selected from the group consisting of polyacrylates, polysulfone resins, epoxy resins, fluoropolymer resins, silicone resins or butyl rubbers.

2. A laminate as claimed in claim 1, characterized in that at least one layer of support material is directly joined on either side to a layer of no longer formable fully aromatic polyimide.

3. A laminate as claimed in claim 1 or 2, characterized in that the thickness of each layer of polyimide is from 1 µm to 1 mm.

4. A laminate as claimed in claim 3, characterized in that the thickness of each layer of polyimide is from 10 µm to 1 mm.

5. A laminate as claimed in claim 3, characterized in that the thickness of each layer of polyimide is from 50 to 250 µm.

6. A laminate as claimed in one or more of claims 1 to 5, characterized in that all layers of polyimide have the same thickness.

7. A laminate as claimed in one or more of claims 1 to 6, characterized in that one or more of the layer of polyimide consist(s) of a polyimide which has the following recurring structure:

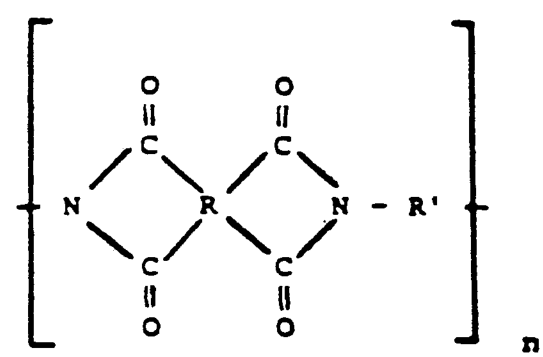

in which

R is a tetrafunctional aromatic radical and

R′ is a difunctional aromatic radical.

8. A laminate as claimed in claim 7, characterized in that R represents

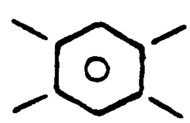

and R′ represents

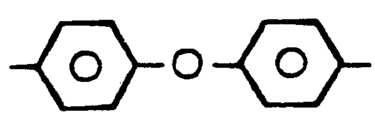

9. A laminate as claimed in one or more of claims 1 to 8, characterized in the support material is a foil of a metal or a metal alloy and/or a polymer film and/or a flat fibrous material.

10. A laminate as claimed in claim 9, characterized in that the support material is a foil of copper, nickel, aluminium or an alloy containing one or more of these metals as principal constituent or a foil of amorphous metal or a foil of steel.

11. A laminate as claimed in claim 10, characterized in that the foil consists of rolled, annealed copper or of a rolled, annealed copper alloy.

12. A laminate as claimed in claim 10 or 11, characterized in that the thickness of the foil is from 5 to 110 µm.

13. A laminate as claimed in claim 12, characterized in that the thickness of the foil is from 10 to 50 µm.

14. A laminate as claimed in one or more of claims 1 to 13, characterized in that the high-temperature adhesive contains fibres.

15. A laminate as claimed in claim 14, characterized in that the fibres are glass, silica, aramide and/or carbon fibres.

16. A laminate as claimed in claim 14 or 15, characterized in that the fibres are in the form of a woven cloth of endless filaments.

17. A laminate as claimed in one or more of claims 1 to 16, characterized in that at least one layer of polyimide and/or the layer of high-temperature adhesive contains particles of polytetrafluoroethylene.

18. A laminate as claimed in one or more of claims 1 to 17 obtainable by application of a polyamide acid solution formed from an aromatic tetracarboxylic acid or dianhydride and a primary aromatic diamine to a support material without an intermediate layer and heating of the support material thus coated, the aromatic tetracarboxylic acid or dianhydride being reacted with an aromatic diamine in a molar ratio of 0.95:1 to 1.05:1 in a polar solvent to form a polymer compound of a polyamide acid corresponding to the following formula

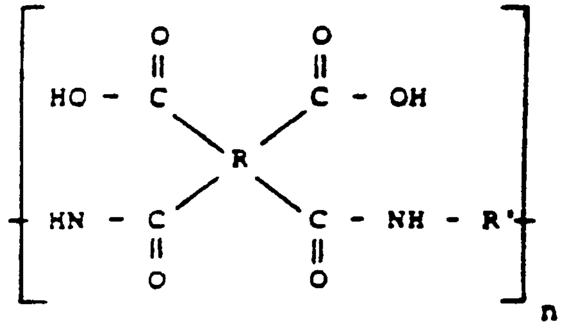

in which

R is an aromatic tetrafunctional radical and R' is a difunctional aromatic radical and n is sufficient to obtain a polyamide acid having a $\eta_{red}$ value of at least 0,5, as measured on a 0.5% solution in dimethylacetamide containing 0.1 mol/litre lithium bromide, removal of the solvent *in situ* from the polyamide acid solution obtained on the support material in a first step in which the temperature is from 100 to 200°C, substantially the entire quantity of solvent being removed, and curing of the film *in situ* in a second step in which the temperature is above 200°C and preferably above 300°C to form a no longer formable polyimide insoluble in phenolic solvents, at least 95% of the polyamide acid being reacted to polyimide, so that a single clad is obtained, after which a heat-sealable high-temperature adhesive selected from the group consisting of polyacrylates, polysulfone resins, epoxy resins, fluoropolymer resins, silicone resins or butyl rubbers is applied to that side of the polyimide layer remote from the support material and the laminate thus obtained is joined to a second single clad containing a layer of heat-sealable high-temperature adhesive at a temperature of 140 to 500°C, the single clads being bonded to the exposed sides of the layers of high-temperature adhesive.

19. A laminate as claimed in claim 18, characterized in that at least one of the support materials contains a foil or copper, nickel, aluminium or an alloy containing one or more of these metals as principal constituent or a foil of amorphous metal or a foil of steel.

20. A laminate as claimed in claim 18 or 19, characterized in that the high-temperature adhesive was used in the form of a film.

21. A process for the production of the laminates claimed in one or more of claims 1 to 17, characterized in that a polyamide acid solution formed from an aromatic tetracarboxylic acid or dianhydride and a primary aromatic diamine is applied to a support material without an intermediate layer and the support material thus coated is heated, the aromatic tetracarboxylic acid or dianhydride being reacted with an aromatic diamine in a molar ratio of 0.95:1 to 1.05:1 in a polar solvent to form a polymer compound of a polyamide acid corresponding to the following formula:

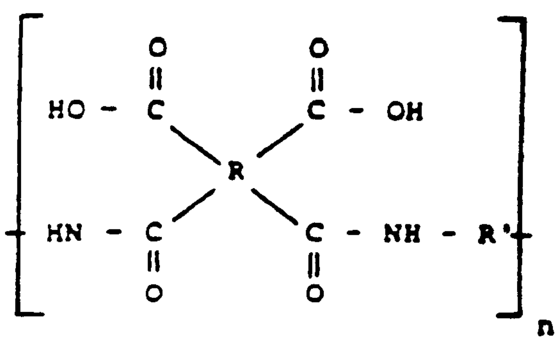

in which

R is an aromatic tetrafunctional radical and R' is a difunctional aromatic radical and n is sufficient to obtain a polyamide acid having a $\eta_{red}$ value of at least 0,5, as measured on a 0.5% solution in dimethylacetamide containing 0.1 mol/litre lithium bromide, the solvent is removed *in situ* from the polyamide acid solution obtained on the support material in a first step in which the temperature is from

100 to 200°C, substantially the entire quantity of solvent being removed, and the film is cured *in situ* in a second step in which the temperature is above 200°C and preferably above 300°C to form a no longer formable polyimide insoluble in phenolic solvents, at least 95% of the polyamide acid being reacted to polyimide, so that a single clad is obtained, after which a heat-sealable high-temperature adhesive selected from the group consisting of polyacrylates, polysulfone resins, epoxy resins, fluoropolymer resins, silicone resins or butyl rubbers is applied to that side of the polyimide layer remote from the support material and the laminate thus obtained is joined to a second single clad containing a layer of heat-sealable high-temperature adhesive at a temperature of 140 to 500°C, the single clads being bonded to the exposed sides of the layers of high-temperature adhesive.

22. A process as claimed in claim 21 for the production of laminates, characterized in that the support material coated with the polyamide acid solution is passed continuously through at least two heating zones with increasing temperature.

23. A process as claimed in claim 21 or 22 for the production of laminates, characterized in that the reaction of the aromatic tetracarboxylic acid or dianhydride with the aromatic diamine to the polyamide acid solution is carried out in an extruder.

24. A process as claimed in one or more of claims 21 to 23 for the production of laminates, characterized in that the polyamide acid solution is continuously dosed by a mixing and feed unit and is extruded onto the support material through a shaped opening.

25. A process as claimed in one or more of claims 21 to 23 for the production of laminates, characterized in that the polyamide acid solution is applied to the support material by knife coating.

26. A process as claimed in one or more of claims 21 to 25 for the production of laminates, characterized in that, in the second step, the film is heated to a temperature of 300 to 600°C.

27. A process as claimed in one or more of claims 21 to 26 for the production of laminates, characterized in that the polar organic solvent is an aprotic solvent.

28. A process as claimed in claim 7 for the production of laminates, characterized in that the aprotic polar organic solvent is dimethyl acetamide, dimethyl formamide, N-methyl-2-pyrrolidone and/or dimethyl sulfoxide.

29. A process as claimed in one or more of claims 21 to 28 for the production of laminates, characterized in that a foil of a metal or a metal alloy and/or a polymer film and/or a flat fibrous material is used as the support material.

30. A process as claimed in claim 29 for the production of laminates, characterized in that a foil of copper, nickel, aluminium or an alloy containing one or more of these metals as principal constituent or a foil of amorphous metal or a foil of steel is used as the support material.

31. A process as claimed in claim 30 for the production of laminates, characterized in that the foil consists of rolled, annealed copper or of a rolled, annealed copper alloy.

32. A process as claimed in claim 30 or 31 for the production of laminates, characterized in that the surface of the support material to be coated with the polyamide acid solution is roughened or edged beforehand by mechanical and/or chemical treatment.

33. A process as claimed in claim 32 for the production of laminates, characterized in that the chemical and/or mechanical pretreatment is carried out in such a way that the surface of the support material to be coated has a mean roughness value of a least 0.20 µm.

34. A process as claimed in one or more of claims 21 to 33 for the production of laminates, characterized in that the high-temperature adhesive is used in the form of a film.

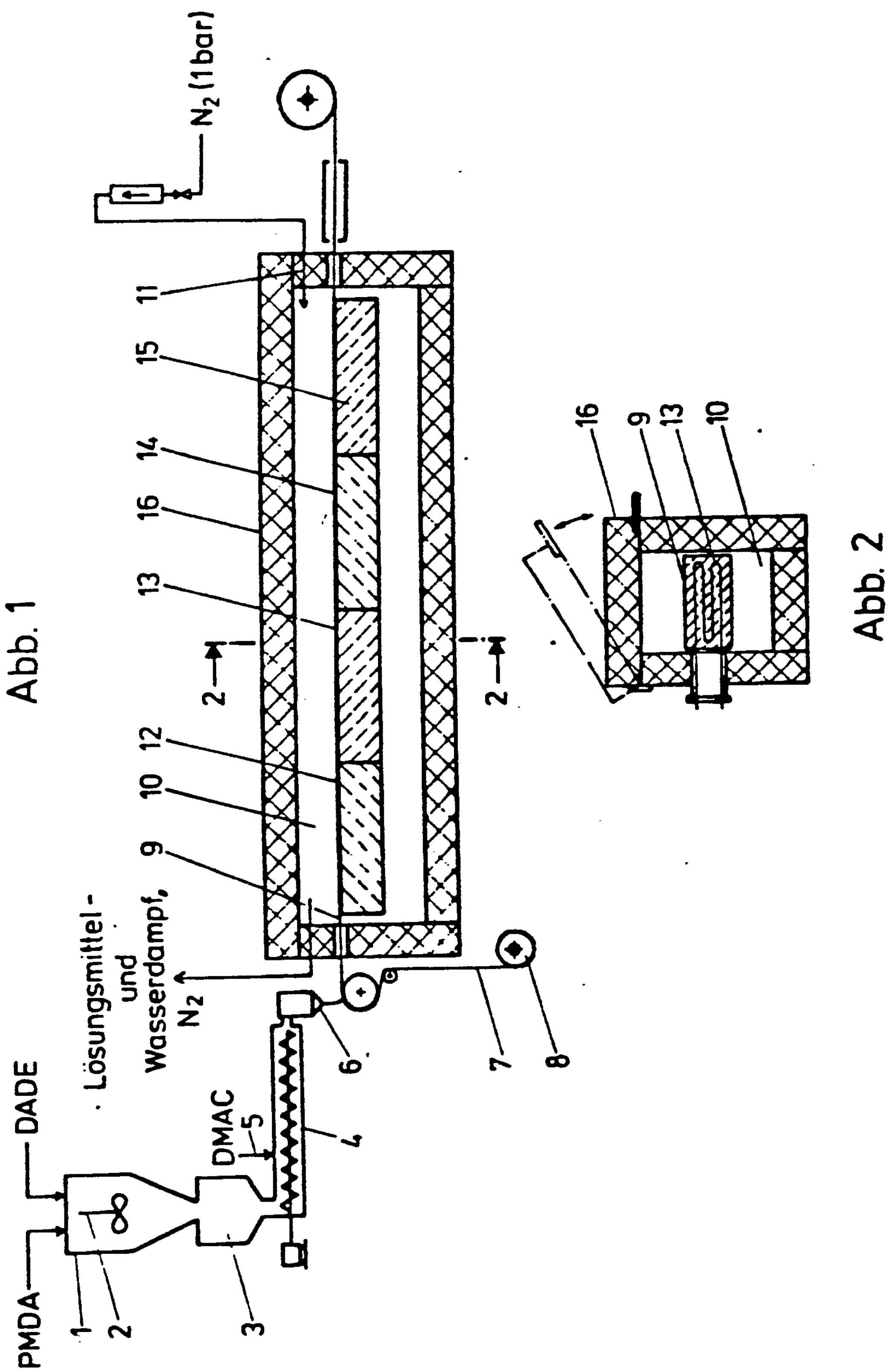
PMDA
DADE
DMAC
Lösungsmittel- und Wasserdampf, $N_2$
$N_2$ (1 bar)
1
2
3
4
5
6
7
8
9
10
11
12
13
14
15
16
2
2
16
9
13
10
Abb. 1

Abb. 2